(19) Europäisches Patentamt
European Patent Office
Office européen des brevets

(11) **EP 4 276 726 A1**

(12) **EUROPÄISCHE PATENTANMELDUNG**

(43) Veröffentlichungstag:
**15.11.2023 Patentblatt 2023/46**

(21) Anmeldenummer: **23172164.8**

(22) Anmeldetag: **08.05.2023**

(51) Internationale Patentklassifikation (IPC):
**G06Q 30/04** (2012.01)  **G06F 30/13** (2020.01)
**G06Q 50/08** (2012.01)

(52) Gemeinsame Patentklassifikation (CPC):
**G06Q 50/08; G06F 30/13; G06Q 10/103;**
**G06Q 30/0283; G06Q 30/04**

(84) Benannte Vertragsstaaten:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Benannte Erstreckungsstaaten:
**BA**
Benannte Validierungsstaaten:
**KH MA MD TN**

(30) Priorität: **12.05.2022 BE 202205359**

(71) Anmelder: **Rippin GmbH**
**46483 Wesel (DE)**

(72) Erfinder: **Rippin, Lutz**
**46483 Wesel (DE)**

(74) Vertreter: **Rössler, Thomas**
**Luxpatent Intellectual Property**
**Zavelput 17**
**1000 Brussel (BE)**

(54) **COMPUTERPROGRAMM, MENSCH-MASCHINE-SCHNITTSTELLE UND VERFAHREN ZUR COMPUTERGESTÜTZTEN ERSTELLUNG UND PRÜFUNG BAUTECHNISCHER AUFMASSE**

(57) Die vorliegende Erfindung schafft eine technische computergestützte Lösung für die Durchführung und Prüfung von beispielsweise bautechnischen Aufmaßen. Dies wird durch eine besondere Datenstruktur und eine besondere Mensch-Maschine-Schnittstelle, welche aufeinander abgestimmt sind, erreicht. Es wird zudem die Prüfqualität verbessert, die Datenintegrität erhöht und es können Betrugsversuche leichter aufgedeckt werden. Insbesondere wird jedoch die Effizienz des Ablaufs der Prozesse gesteigert, da die unterschiedlichen Nutzer bei ihren Aufgaben durch die vorliegende Erfindung unterstützt und hierdurch effizienter werden. Dem Einsatz der Verbesserung kommt eine hohe praktische und damit verbundene hohe wirtschaftliche Relevanz zu. Die u.a. die Anforderungen der MMS wiederspiegelnde Low-Level-Datenstruktur sorgt für eine zusätzliche effizientere Nutzung der Rechnerkapazitäten (insb. Speicher und Laufzeit).

Fig. 11

EP 4 276 726 A1

## Beschreibung

### Gebiet der Erfindung

Die vorliegende Erfindung bezieht sich auf das technische Gebiet der Bau- und Gebäudekonstruktionstechnik, insbesondere des Trockenbaus.

Hierbei gibt es ein häufig auftretendes komplexes Prozesskonglomerat an Abnahme-, Prüf-und Abrechnungsprozessen, welche von beteiligten Personen im Wesentlichen manuell und kaum unter Zuhilfenahme von technischen Mitteln und Lösungen durchlaufen werden.

Dies führt zu redundanten Arbeits- und Prüfabläufen, ist ineffizient und höchst unwirtschaftlich.

Die Erfindung hat sich zur Aufgabe gemacht, technische Lösungen zu schaffen, welche den beteiligten Personen schnelle Eingaben, Ausgaben und Prüfmöglichkeiten und hierdurch effiziente und wirtschaftlich tragfähigere Prozesse erlauben.

### Technischer Hintergrund

Bei der Umsetzung, Prüfung und Abrechnung moderner Bauvorhaben sind zahlreiche Parteien involviert, welche in Zusammenarbeit ein gemeinsames Vorhaben komplexer Struktur zu bewältigen gedenken: Architekten, Bauträger, Auftragsnehmer, um nur einige zu nennen.

In einer bekannten Vorgehensweise werden Baupläne für ein geplantes, umzusetzendes Bauvorhaben erstellt. Hierzu kann beispielsweise ein Architekt bautechnische Zeichnungen anfertigen, welche die wichtigen Bauinformationen des vom Architekten entworfenen Objektes - häufig in Form einer schematischen, maßstabsgetreuen Bauzeichnung - enthalten.

Zudem werden Leistungsverzeichnisse zum Einsatz gebracht. Ein Leistungsverzeichnis kann beispielsweise von einem Architekten erstellt werden. Die im Leistungsverzeichnis enthaltenen Leistungspositionen können beispielsweise genauer quantifizieren, wieviel Material oder wie viele Objekte eines bestimmten Gattungstyps (z.B. Deckenanschlusswinkel für eine Decke, oder WC-Tragständer für ein Badezimmer) für die Umsetzung des Bauvorhabens benötigt werden. Solche Leistungsverzeichnisse können mit Kostenschätzungen versehen sein, und dabei helfen, die Gesamtkosten eines Bauvorhabens - beispielsweise auch bereits im Vorfeld - abzuschätzen.

In einer branchenüblichen Vorgehensweise erfolgt später ein sogenanntes Aufmaß von Leistungspositionen, d. h. tatsächlich verbrauchten und/oder erbrachten Material- und/oder Leistungsmengen. Dies ist erforderlich, da Rechnungen für Bauleistungen nach tatsächlich erbrachten Leistungen und nicht nach lediglich vorab geplanten Leistungen oder Materialmengen erstellt werden.

Ein sogenanntes Aufmaß wird hierzu durchgeführt. Im Prinzip ist ein Aufmaß eine Mengen- bzw. Massenermittlung für die Leistungspositionen. So werden die tatsächlich verbrauchten Mengen aufgemessen, und hierauf wird eine Rechnung erstellt, die ebenfalls die Leistungspositionen enthält, wobei nun gegenüber dem Bauträger oder dem Bauherrn tatsächlich verbrauchtes Material bzw. tatsächlich erbrachte Leistungen im Rahmen der Leistungspositionen abgerechnet werden.

Häufig geht es um hohe Geldbeträge, und es gibt rechtliche Rahmenbedingungen für derartige Abrechnungen (z.B. in Deutschland: VOB/B, BGB, manchmal eigene Vertragsbestimmungen oder AGBs...). Daher wird häufig eine Prüfung der Rechnung und der hierin enthaltenen Leistungspositionen durch einen unabhängigen Prüfer, beispielsweise auch einen Architekten, durchgeführt.

Dieser hat nun die Aufgabe, abermals anhand von bautechnischen Zeichnungen, zu schauen, ob die Rechnung stimmt. Häufig geschieht dies "Objekt für Objekt" unter manuellem Durchkämmen sämtlicher Leistungspositionen, und ohne geeignete Hinweise, welche ein schnelles Auffinden und Verifizieren in den bautechnischen Zeichnungen ermöglichen. Geläufig ist beispielsweise lediglich die Identifikation anhand einer Raumnummer: Beispielsweise wird in einer Leistungsposition auf die beiden WC-Tragständer in Raum 603b-2 verwiesen, und der Prüfer muss manuell in den Zeichnungen diesen Raum aufsuchen, um dort die Leistungspositionen verifizieren zu können.

Die Pläne sind, erschwerend für den Prüfer, häufig vollkommen mit Informationen überladen.

Auf der anderen Seite wird sodann häufig von den Prüfern die "Unprüfbarkeit" bestimmter Leistungspositionen geltend gemacht. Besonders "gern" geschieht dies als Vorwand am letzten möglichen Tag zur Begleichung der Rechnung. So kann der Bauherr seine Liquidität einstweilig erhöhen, zu Lasten des Bauauftragsnehmers, da er die unprüfbare Rechnung zunächst nicht bezahlen muss. Der Bauauftragsnehmer könnte hierdurch zudem in einen Liquiditätsengpass geraten, da das verbrauchte Baumaterial und die Mitarbeiter bereits zu bezahlen sind, aber ihm das vom Bauherrn oder Bauträger zu zahlende Geld so nicht frühzeitig nach Abschluss der Arbeiten, sondern erst verspätet nach Klärung sämtlicher "Prüfbarkeitsfragen" zufließen wird. So gibt es in der Praxis einen gewissen Missbrauch der rechtlichen Regelungen zur "(Un)Prüfbarkeit".

Die vorliegende Erfindung hat sich zur Aufgabe gemacht, diesen Problemen durch Schaffung einer modernen, technischen Lösung ein Ende zu bereiten. Sowohl die Erstellung eines Aufmaßes, das Bearbeiten, das Verwalten als auch das Prüfen sollen bequem, präzise und zuverlässig ermöglicht werden. Dabei soll ein hohes Maß an Automatisierung bereitgestellt werden, jedoch weitaus mehr. Die verwendeten Datenstrukturen sollen besonders an die Problemstellungen angepasst sein, um technische Ressourcen zu schonen, aber insbesondere soll eine Manipulierbarkeit durch jegliche an den Prozessen beteiligte Parteien erschwert werden. Die Sicherung der Integrität der Daten, als auch eine strukturierte, übersichtliche Vorgehensweise bei deren Verifizierung sollen dabei eine besondere Priorität haben. Es sollen besondere Benutzeroberflächen bereitgestellt werden, insbesondere auf Grundlage der vorteilhaften erfindungsgemäßen Datenstrukturen, welche die verschiedenen Nutzer bei den Datenverarbeitungs- und -prüfungsaufgaben bestmöglich unterstützen. Dabei soll den kognitiven Eigenschaften der (humanen) Benutzer - insbesondere der begrenzten menschlichen kognitiven Kapazität, innerhalb bestimmter Zeitspannen und/oder gleichzeitig mehrere Verwaltungs- und/oder Prüf-/Verifikations-Tasks gründlich, fehlerfrei und erfolgreich zu bearbeiten - besondere Rechnung getragen werden. Idealerweise soll die Problemlösung technische Vorteile gleichzeitig bieten mit kognitiven Vorteilen der verarbeitenden Nutzer, welche über eine Nutzerschnittstelle mit den Datenstrukturen interagieren. Beispielsweise, wenngleich nicht hierauf limitiert, soll die Nutzerschnittstelle besondere kognitive Vorteile für die Nutzer bei deren Tätigkeiten bieten, wobei die zugrundeliegenden, im Hintergrund arbeitenden Datenstrukturen technisch optimiert sind, ebendiese kognitiv vorteilhafte Nutzerschnittstelle unter Schonung technischer Ressourcen möglichst effizient mit technischen Mitteln bereitzustellen.

Der vorliegenden Erfindung liegt daher insbesondere die technische Aufgabe zugrunde, technische Lösungen für Computersoftware und Verfahren bereitzustellen, die die Nachteile des Standes der Technik überwinden und neue Lösungen ermöglichen. Insbesondere soll ein Computerprogramm, hierzu passende Datenstrukturen und ferner eine hierzu passende Nutzerschnittstelle zum effizienten Aufmessen von Leistungspositionen, Erstellen von Leistungsverzeichnissen, Aufmaßdokumenten sowie Rechnungen bereitgestellt werden. Zudem soll effiziente und skalierbare Methodik und Struktur für die Aufmaß- und Rechnungsprüfung geschaffen werden. Die bereitgestellte Lösung soll gute Performanz- und Laufzeiteigenschaften aus technischer Sicht haben, ferner jedoch Nutzer tatsächliche (messbare und damit unmittelbar wirtschaftlich vorteilhafte) Effizienzsteigerungen bei der Lösung ihrer Arbeitsaufgaben bieten. Hierdurch sollen der Betrieb und die Zusammenarbeit im Bausektor durch moderne technische Mittel gefördert und erleichtert werden sowie Kosten eingespart werden. Zudem wird die Arbeitsqualität der Nutzer zuletzt noch dadurch verbessert, dass die Arbeit unter Nutzung der vorgeschlagenen Lösung als deutlich "befriedigender" (u.a. da effizienter und produktiver) wahrgenommen wird. Die Erfindung soll also die Produktivität messbar steigern, aber auch wie sie kognitiv wahrgenommen wird.

Ein weiteres Kriterium ist, dass flexiblere, skalierbare, übertragbare, sicherere, verlässlichere Lösungen geschaffen werden sollen.

Die Nachteile des Standes der Technik werden überwunden durch das Computerprogramm nach Anspruch 1, das Verfahren zum Aufmessen von Leistungspositionen nach Anspruch 3, das Verfahren zum Prüfen eines Aufmaßes nach Anspruch 14, die entsprechend erzeugten Aufmaßdaten nach Anspruch 17 sowie die unabhängigen Ansprüche der übrigen Anspruchskategorien.

Die Erfindung trägt damit erheblich zum technischen Fortschritt u.a. im Bausektor bei, insbesondere durch Schonung technischer Ressourcen, in Kombination mit einer intuitiven an die Arbeits- und Prüfaufgaben speziell angepassten Nutzeroberfläche und hierzu passender Datenverarbeitung durch entsprechende Datenstrukturen im Hintergrund. Durch diese vorgeschlagene technische Lösung wird die Datenintegrität erhöht und Manipulierbarkeit (versehentlich oder in Betrugsabsicht) wird verringert, d.h. sowohl unabsichtliche Arbeitsfehler als auch absichtliche Manipulation werden erschwert.

**Beschreibung der Erfindung**

Die vorliegende Erfindung schafft ein Computerprogramm mit den Merkmalen des Anspruchs 1.

Weitere vorteilhafte Ausgestaltungen sind in den Unteransprüchen angegeben.

Demgemäß ist ein Computerprogramm vorgesehen. Es kann für ein Aufmaß eines Gebäudes, Gebäudeteils oder anderweitigen Bauobjektes oder -projektes vorgesehen sein. Beispielsweise geschieht dies unter Nutzung mindestens einer bautechnischen Zeichnung. Das Computerprogramm kann dazu eingerichtet sein, ein Aufmaß ein oder mehrerer in der Zeichnung verzeichneter Leistungspositionen bereitzustellen und/oder vorzunehmen, beispielsweise durch ein Aufmessen einer oder mehrerer Aufmaßgrößen. Aufmaßgrößen können Layerebenen zugeordnet werden. Den Layerebenen können layerebenenspezifische Berechnungsvorschriften zugeordnet werden. Diese können beispielsweise zwischen den einzelnen Layerebenen variieren. Das Computerprogramm kann ferner dazu eingerichtet sein, die Aufmaßgrößen einer Layerebene entsprechend der layerebenenspezifischen Berechnungsvorschriften der jeweiligen Layerebene weiterzuverarbeiten. Dabei kann ein Aufmaßgrößenresultat erzeugt werden. Beispielsweise wird letzteres angezeigt oder anderweitig ausgegeben oder bereitgestellt.

Die vorliegende Erfindung schafft ferner ein Verfahren mit den Merkmalen des Anspruchs 3.

Weitere vorteilhafte Ausgestaltungen sind in den Unteransprüchen angegeben.

Demgemäß ist ein Verfahren zum Aufmessen von Leistungspositionen vorgesehen, beispielsweise in Bezug auf mindestens eine bautechnische Zeichnung. Es kann ein Schritt eines Bereitstellens mindestens einer Layerebene zur Aufnahme von Aufmaßobjekten vorgesehen sein. Es kann ein Schritt eines Bereitstellens oder Vornehmens eines Aufmaßes vorgesehen sein. Beispielsweise geschieht dies für eine oder mehrere Leistungspositionen und/oder mit Hilfe von Aufmaßobjekten, beispielsweise unter Zuordnung der Aufmaßobjekte zu einer Layerebene. Ein weiterer Schritt kann in einem Bereitstellen einer layerebenenspezifischen Berechnungsvorschrift bestehen und/oder einem Zuordnen der layerebenenspezifischen Berechnungsvorschrift zu einer Layerebene. Es kann ein Ermitteln mindestens einer Aufmaßgröße auf Basis eines Aufmaßobjektes vorgesehen sein. Ein Weiterverarbeiten mindestens einer Aufmaßgröße einer Layerebene kann vorgesehen sein. Dies kann entsprechend der layerebenenspezifischen Berechnungsvorschriften der jeweiligen Layerebene geschehen. Hierbei wird beispielsweise mindestens ein Aufmaßgrößenresultat erhalten, bereitgestellt und/oder ausgegeben.

Ferner schafft die Erfindung ein Verfahren mit den Merkmalen des Anspruchs 14. Demgemäß ist ein Verfahren zum Prüfen eines Aufmaßes auf Korrektheit vorgesehen. Dies kann einen oder mehrere der folgenden Schritte umfassen: Bereitstellen mindestens einer Layerebene zur Aufnahme von Aufmaßobjekten, Bereitstellen einer layerebenenspezifischen Berechnungsvorschrift, welche beispielsweise der mindestens einen Layerebene zugeordnet ist, Bereitstellen eines Aufmaßgrößenresultats, welches beispielsweise zu prüfen ist, in Bezug auf eine Leistungsposition eines Leistungsverzeichnisses, Prüfen, insbesondere Veri- oder Falsifizieren, insbesondere indirektes Prüfen, eines Aufmaßgrößenresultats, welches beispielsweise einen oder meherere der folgenden zwei Unterschritte umfassen kann: Prüfen von Aufmaßgrößen, beispielsweise in Bezug auf Aufmaßobjekte, beispielweise der mindestens einen Layerebene und/oder Prüfen der layerebenenspezifischen Berechnungsvorschrift.

Die Erfindung schafft ferner die Aufmaßdaten nach Anspruch 17.

Demgemäß sind Aufmaßdaten, beispielsweise in Bezug auf mindestens eine bautechnische Zeichnung, vorgesehen. Dabei kann eine Aufteilung in mehrere Layerebenen vorgesehen sein. Die Daten können Aufmaßobjekte umfassen. Die Daten können ferner zugehörige Aufmaßgrößen umfassen. Diese können den Layerebenen zugeordnet sein. Es kann mindestens eine layerebenenspezifische Berechnungsvorschrift vorgesehen sein. Diese kann/können jeweils einer Layerebene zugeordnet sein. Es kann mindestens ein Aufmaßgrößenresultat enthalten sein. Ein solches kann sich beispielsweise dadurch ergeben, dass die layerebenenspezifische Berechnungsvorschrift einer Layerebene auf mindestens eine Aufmaßgröße, beispielsweise der besagten Layerebene, angewandt wird. Es kann sich auch um ein hieraus abgeleitetes weiteres Resultat handeln, insbesondere beispielsweise die Summe der Ergebnisse der Berechnungen der Anwendung der layerebenenspezifischen Berechnungsvorschrift auf sämtliche in einer Layerebene vorhandene Aufmaßgrößen.

Es handelt sich um miteinander in Beziehung stehende Verfahren, Erzeugnisse (vgl. Regel 43(2)a) EPC). So werden beispielsweise Aufmaßdaten mittels eines Computerprogrammes erzeugt, gemäß einem Verfahren zum Aufmessen von Leistungspositionen, und können sodann vereinfacht geprüft werden.

Aufmaßgrößen stellen konkret ermittelte Mengen dar. Beispielsweise können Aufmaßgrößen aus Aufmaßobjekten abgeleitet werden. Beispielsweise ist ein Aufmaßobjekt durch eine Wand gegeben bzw. wird in einer bautechnischen Zeichnung durch ein Aufmaßobjekt repräsentiert. Beispielsweise ist dies eine Linie oder eine Polylinie. Ein Aufmaßobjekt kann also beispielsweise eine Linie oder eine Polylinie sein. (Eine Polylinie kann dabei im Gegensatz zu einer Geraden einmal oder mehrmals "abknicken".) Eine Aufmaßgröße ist beispielsweise "2,30m", beispielsweise für eine 2,30m lange Wand. Aufmaßgrößen sind jedoch in den verschiedensten Einheiten und Größen möglich, beispielsweise darunter Längen, Flächen uvm. (z.B. Quadratmeter, Stückzahlen, etc.).

Aufmaßobjekte und dazugehörige Aufmaßgrößen verweisen beispielsweise auf Leistungspositionen. Leistungspositionen (z.B.: Leistungsposition für eine Metallständerwand) sind in bautechnischen Zeichnungen verzeichnet. Das Aufmaß der Leistungsposition kann nun mittels eines Aufmaßobjektes erfolgen (z.B. einer Linie oder einer Polylinie als Aufmaßobjekt für die in der Zeichnung verzeichnete Metallständerwand).

Auf eine Leistungsposition wird im Bauwesen häufig durch eine Positionsnummer, auch genannt Ordnungszahl, Bezug genommen. Eine solche Positionsnummer bzw. Ordnungszahl kann beispielsweise lauten wie folgt: 39.01.040.

Beispielsweise ist dies eine Leistungsposition für eine Metallständerwand. In einem typischen Aufmaßdokument finden sich so häufig Auflistungen von Leistungspositionen, und pro Leistungsposition häufig mehrere Aufmaßzeilen. Beispielsweise wird an verschiedenen Stellen einer bautechnischen Zeichnung jeweils eine Metallständerwand verbaut, jeweils von unterschiedlicher Länge. Der Typ der Metallständerwand ist jedoch der gleiche. Dann finden sich die jeweiligen verbrauchten "Stücke" der Metallständerwand beispielsweise in Form von mehreren Aufmaßzeilen, allesamt zugeordnet zu und aufgelistet in der passenden Leistungsposition.

Aufmaßgrößen können Layerebenen zugeordnet werden. Aufmaßobjekte können ebenfalls Layerebenen zugeordnet werden.

Die Erfindung zeichnet sich unter anderem dadurch aus, dass sie layerebenenspezifische Berechnungsvorschriften ermöglicht und gewinnbringend nutzt. Der Begriff Layer bzw. Layerebene ist dabei im Kontext dieser Erfindung keineswegs auf eine graphische Lösung beschränkt, sondern vielmehr als logische Einheit zu verstehen. Es wird jedoch im Rahmen dieser Erfindung immer der Begriff "Layer" oder "Layerebene" benutzt werden, da eine graphisch-logische Vorstellung eines Layers eine sehr anschauliche Variante der vorliegenden Erfindung darstellt. Die Erfindung möchte sich jedoch keineswegs auf eine solche, zu enge Auslegung des Begriffes "Layer" beschränken. Beispielsweise kann es auch eine rein logische Struktur und/oder Gruppierung sein, ohne dass notwendigerweise eine unmittelbare graphische Darstellung in Form einer oder mehrere sich überlagernder Ebenen ("Layer" im engerem Sinne) darstellt. In anderen Worten können "Layer" oder "Layerebenen" durch verschiedenste logische Strukturen geschaffen werden. Diese Strukturen können lediglich beispielhaft als sich überlagernde Ebenen visualisiert werden.

Wichtig für die Erfindung ist, dass die Möglichkeit besteht, diesen Layerebenen spezielle Berechnungsvorschriften (genannt: layerebenenspezifische Berechnungsvorschriften) zuzuordnen oder zuzuweisen (bzw. dass eine solche Zuweisung existiert, beispielsweise in Aufmaßdaten).

Die Aufmaßgrößen (bzw. Aufmaßobjekte) einer Layerebene werden dann allesamt gemäß der layerebenenspezifischen Berechnungsvorschrift der jeweiligen Layerebene, welcher die Aufmaßgrößen selbst zugeordnet sind, weiterverarbeitet.

Layerebenenspezifische Berechnungsvorschriften können vielerlei mathematische Operationen und Operatoren enthalten, insbesondere solche, welche auf die Aufmaßgrößen wirken. Die Erfindung ist hier nicht limitiert. Beispielsweise können solche Berechnungsvorschriften auch dazu genutzt werden, um den unterschiedlichsten Gründen Rechnung zu tragen, darunter tatsächliche Abweichungen, Implementierungsdetails oder auch rechtliche Vorgaben (z.B. auch rechtliche Vorschriften in Bezug auf die Vornahme eines Aufmaßes und/oder die Abrechnung der Leistungspositionen). Durch die geschaffene technische Lösung können sämtliche derartige Fallkategorien abgedeckt werden. Bei tatsächlichen Abweichungen wurde beispielsweise mehr oder weniger von einer Leistung benötigt, als sich dies unmittelbar aus der bautechnischen Zeichnung entnehmen lässt. Implementierungsdetails können vielfältig sein. Häufig wird jedoch Details Rechnung getragen, welche in der bautechnischen Zeichnung nicht aufgelöst sind. Beispielsweise ist ein WC verzeichnet. Die Berechnungsregel kann dem Umstand Rechnung tragen, dass hierfür zwei UA-Profile, und zwar jeweils in Wandhöhe, benötigt werden. Auch für rechtliche Vorgaben kann die layerebenenspezifische Berechnungsregel genutzt werden. Beispielsweise darf eine Wand vorschriftsmäßig bis zu einem hinter einer Verputzung liegenden Punkt abgerechnet werden, auch wenn diese tatsächlich, wegen der Verputzung, nur bis zur Oberfläche des Putzes reicht. Sowohl diese Kategorien und Anwendungsfälle als auch die konkret genannten Beispiele limitieren die Erfindung jedoch nicht.

Layerebenenspezifische Berechnungsvorschriften können sich insbesondere, von Layerebene zu Layerebene unterscheiden. Sie können sich auch insbesondere zwischen verschiedenen Leistungspositionen unterscheiden. Beispielsweise sollen Aufmaßgrößen zu Rasterdecken, welche beispielsweise als Flächenmaß aufgemessen werden, anders weiterverarbeitet werden als beispielsweise eine Deckenschürze, welche beispielsweise als Länge aufgemessen wird. So ein Umstand lässt sich in einer angepassten layerebenenspezifischen Berechnungsregel umsetzen.

Eine Metallständerwand kann beispielsweise auch, genau wie eine Deckenschürze, zunächst durch eine Polylinie als Aufmaßobjekt aufgemessen werden. Während jedoch die Deckenschürze beispielsweise tatsächlich in [m] aufgemessen wird, so wird die Metallständerwand als Fläche in [m2] aufgemessen. Eine entsprechende Weiterverarbeitung durch eine Berechnungsvorschrift kann diesem Umstand Rechnung tragen.

Layerebenen können auch Leistungspositionen zugeordnet werden. Beispielsweise umfasst eine Leistungsposition eine Layerebene. Dann ist sozusagen diese Leistungsposition in der Layerebene "verklausuliert". Es können aber auch mehrere Layerebenen für eine Leistungsposition definiert sein. Hierdurch können für eine Leistungsposition verschiedene layerebenenspezifische Berechnungsregeln zum Einsatz kommen. Beispielsweise sind verschiedene Wände vom gleichen Bautyp und daher derselben Leistungsposition zugeordnet. Beispielsweise sind jedoch diese Wände unterschiedlich hoch. Dieser Umstand kann durch eine layerebenenspezifische Berechnungsregel gebührend berücksichtigt werden.

Zudem gibt die Möglichkeit der Zuordnung auch mehrerer Layerebenen zu einer Leistungsposition mehr Flexibilität für weitere Unterteilungen, um überladene Layerebenen zu vermeiden und die Übersichtlichkeit zu wahren.

Die Layerebenen haben also im Rahmen der Erfindung eine technische Bedeutung, welche über eine schlichte Einteilung in graphische Überlagerungsebenen und/oder in gruppierte Objekte hinausgeht. Sie sind beispielsweise nicht willkürlich, sondern im Hinblick auf die anpassbare layerebenenspezifische Berechnungsvorschrift (im Folgenden synonym: Berechnungsregel) gewählt.

Ein Aufmaßgrößenresultat kann bereits die Anwendung einer layerebenenspezifischen Berechnungsvorschrift auf eine einzelne ermittelte Aufmaßgröße sein. So entsteht beispielsweise eine einzelne Aufmaßzeile für die entsprechende Leistungsposition im Aufmaßdokument. Der Begriff Aufmaßgrößenresultat ist jedoch keineswegs hierauf limitiert. Ein weiteres Aufmaßgrößenresultat ergibt sich beispielsweise, wenn die layerebenenspezifische Berechnungsregel auf die Aufmaßgrößen einer Layerebene angewandt wird, wobei über die Aufmaßgrößenresultate summiert wird. (In letzterem Beispiel wird ein Gesamtaufmaß für diese Layerebene errechnet.)

Ein sehr einfaches Anwendungsbeispiel der Erfindung wird im Rahmen der Figurenbeschreibungen erläutert werden.

Die Erfindung erleichtert die Aufmaß- und Prüfprozesse im Bausektor durch eine zeitgemäße technische Lösung. Das Computerprogramm und die verwendete Datenstruktur bieten den verschiedenen Nutzern eine enorme Unterstützung bei der Bearbeitung und Lösung ihrer Aufgaben. Die Mensch-Maschine-Schnittstelle erleichtert die Aufmaß- und Prüfprozesse für alle Beteiligten. Zudem wird die Prüfqualität durch die Mensch-Maschine-Schnittstelle verbessert. Durch die vorgeschlagene Datenstruktur wird die Lösung dieser Aufgaben in technisch performanter und ressourcenschonender Weise bereitgestellt.

Durch das Nutzen der Layerebenen und der spezifischen Berechnungsregel ist die Software Veoplan enorm leistungsstark, insbesondere für große Bauprojekte.

Gemäß einer Weiterbildung werden den Layerebenen Aufmaßobjekte zugeordnet, welche auf eine aufzumessende Leistungsposition verweisen, und die Aufmaßgrößen auf Basis der Aufmaßobjekte ermittelt.

Diese Aufmaßobjekte sind für ein graphisches Aufmaß enorm benutzerfreundlich und hilfreich. Beispielsweise wird eine Polylinie als Aufmaßobjekt verwandt. Es können beispielsweise auch die Aufmaßgrößen sehr präzise bestimmt werden, unter Zuhilfenahme eines Maßstabes einer bautechnischen Zeichnung und/oder von Fangpunkten, welche ein exaktes Anordnen der Aufmaßobjekte zwecks präziser Aufmaßgrößenermittlung ermöglichen.

Gemäß einer Weiterbildung erfolgt der Schritt des Weiterverarbeitens in einem zu der Layerebene gehörigen und/oder der Layerebene, insbesondere eindeutig, zugeordneten Datenbereich. Durch diese Art der Speicherzuordnung werden insbesondere Zugriffszeiten reduziert. Dies schont Rechenressourcen beim Schritt des Weiterverarbeitens, insbesondere der Umsetzung gemäß der layerebenenspezifischen Berechnungsvorschrift und ggf. nachgelagerten Schritten wie Summierung.

Gemäß einer Weiterbildung findet der Schritt des Weiterverarbeitens in der Layerebene selbst statt und/oder bereits zu einem Zeitpunkt einer Erstellung eines Aufmaßobjektes.

Dies schont Ressourcen wie Speicher, Rechenzeit und Bandbreite, da es eine frühzeitige Berechnung (einschließlich damit verbundener Datenreduktion) fördert.

Die Berechnung in der Layerebene selbst kann auch unter Nutzung der Features eines PDF-Viewers erfolgen. PDFs sind weitverbreitet und portabel und können von den, ebenso weit verbreiteten, PDF-Viewern und -Editoren auf verschiedensten Computerplattformen geöffnet und bearbeitet werden. Die Berechnung in der Layerebene unter Nutzung eines PDF-Viewers oder -Editors hat den Vorteil, dass eine zusätzliche Abstraktionsebene geschaffen wird, was gewinnbringend genutzt werden kann. So läuft die Aufmaßsoftware auf unterschiedlichen Plattformen, während die Rechenoperationen von der PDF-Software bereitgestellt werden. Hierdurch muss nur eine Aufmaßsoftware bereitgestellt werden, während technische Optimierungen der Berechnungen, darunter insbesondere spezielle Hardwareanpassungen, auf die PDF-Software verlagert werden.

Gemäß einer Weiterbildung sind die Aufmaßobjekte und/oder Aufmaßgrößen einer Layerebene für den Nutzer darstellbar und gemeinsam ein- und ausblendbar, wobei insbesondere die Aufmaßobjekte und/oder Aufmaßgrößen ausgewählter Layerebenen einzeln und/oder im Kombination dargestellt werden können, insbesondere jeweils auch vor neutraler Grundierung, welche die bautechnische Zeichnung im Hintergrund ausblendet/opak, insbesondere jedenfalls semi-opak, überdeckt.

Dieses Feature erhöht die Übersichtlichkeit enorm, beim Aufmessen, insbesondere auch beim Prüfen. Bautechnische Pläne sind häufig enorm mit Inhalten überladen, was den Betrachter mit graphischen Reizen überflutet. Insbesondere Möglichkeiten zur Voll- oder Teilausblendung des Bauplanes und die Ein- und Ausblendung der einzelnen Layerebenen ist daher sehr nützlich. Die Erfindung schafft so ein vorteilhaftes User Interface, was benutzerfreundlich zu bedienen ist und zu enormer Zeitersparnis führt.

Durch die freie Ein- und Ausblendung von Layerebenen (und darin enthaltenen Aufmaßobjekten und/oder Aufmaßgrößen) kann der Nutzer die durch die Layerebenen definierten Gruppen von Aufmaßobjekten und/oder Aufmaßgrößen jeweils gemeinsam prüfen. Dabei muss er, erfindungsgemäß, pro Layer nur eine einzige layerebenenspezifische Berechnungsvorschrift kennen bzw. einbeziehen. Dies erleichtert den Prozess des Aufmessens als auch eines Prüfens.

Die so geschaffene Mensch-Maschine-Schnittstelle ermöglicht in der Praxis eine enorme Effizienzsteigerung als auch eine simultane Qualitätssteigerung (insbesondere weniger Fehler und verbesserte Aufdeckung von Betrug). Denn durch diese technische Lösung werden die Benutzer bei der Lösung ihrer technischer Aufgaben nachweislich und messbar unterstützt.

Gemäß einer Weiterbildung liegt mindestens eine bautechnische Zeichnung im PDF-Format als bautechnische PDF-Zeichnung vor, wobei für die Realisierung der genannten Layerebenen entsprechende Layer in der PDF-Zeichnung zum Einsatz gebracht werden.

Es gelten die bereits erwähnten Vorteile zur Portabilität und zur plattformunabhängigen Optimierung von Rechenschritten durch einen zusätzlichen Abstraktionslayer. Zusätzlich wird eine Unabhängigkeit von der Kernsoftware geschaffen. Die Verbreitung von PDFs und die bereits vorhandene Layerstruktur von PDFs können so genutzt werden und einen erfindungsgemäßen Einsatz erfahren.

Gemäß einer Weiterbildung wird mindestens eine layerebenenspezifische Berechnungsvorschrift im PDF-Dokument bereitgestellt und/oder in dieses übertragen, und wobei die layerebenenspezifische Berechnungsvorschrift innerhalb des PDF-Dokuments zur rechnerischen Anwendung gebracht wird, insbesondere unter Nutzung einer entsprechenden Funktion eines PDF-Anzeige- und/oder PDF-Verarbeitungsprogrammes zur Auswertung einer Berechnungsvorschrift.

Es gelten die bereits erwähnten Vorteile zur Portabilität und zur plattformunabhängigen Optimierung von Rechenschritten durch einen zusätzlichen Abstraktionslayer.

Gemäß einer Weiterbildung wird eine Leistungsposition auf Basis mindestens eines Aufmaßgrößenresultats erzeugt, ergänzt und/oder geprüft.

So kann mittels der Erfindung ein Leistungsverzeichnis erstellt werden, welches eine oder mehrere Leistungspositionen umfasst. Auch anderweitige Aufmaßdokumente sind möglich. Die Erstellung von Rechnungen ist möglich. Es können auch Leistungverzeichnisse gefüllt und/oder ergänzt werden. Beispielsweise wird ein bereits vor einem Bauvorhaben erstelltes Leistungsverzeichnis mit ausgeschriebenen Mengen für Leistungspositionen mit aufgemessenen Leistungspositionen gefüllt bzw. ergänzt. Oder es wird ein solches Leistungsverzeichnis um sogenannte Nachtragpositionen ergänzt.

In einem weiteren Beispiel kann auch eine Ausschreibung selbst (bzw. ein Leistungsverzeichnis für eine Ausschreibung) unter Nutzung der Erfindung erstellt werden. Eine Ausschreibung ist üblicherweise gröber und basiert stärker auf Abschätzungen als ein späteres Aufmaß. Dennoch lässt sich auch hier die Erfindung gewinnbringend einsetzen.

Gemäß einer Weiterbildung umfasst das Verfahren ferner einen Schritt eines Erstellens, Ergänzens oder Füllens eines Leistungsverzeichnisses aus/mit den Leistungspositionen.

In einem solchen Leistungsverzeichnis finden sich üblicherweise zahlreiche Leistungspositionen. So kann mittels der Erfindung ein Leistungsverzeichnis erstellt werden, welches eine oder mehrere Leistungspositionen umfasst. Auch anderweitige Aufmaßdokumente sind möglich. Die Erstellung von Rechnungen ist möglich. Es können auch Leistungverzeichnisse gefüllt und/oder ergänzt werden. Beispielsweise wird ein bereits vor einem Bauvorhaben erstelltes Leistungsverzeichnis mit ausgeschriebenen Mengen für Leistungspositionen mit aufgemessenen Leistungspositionen gefüllt bzw. ergänzt. Oder es wird ein solches Leistungsverzeichnis um sogenannte Nachtragpositionen ergänzt.

Gemäß einer Weiterbildung wird ein präzises Aufmaß unter Nutzung eines Maßstabes und unter Nutzung von Fangpunkten in der mindestens einen bautechnischen Zeichnung, insbesondere in einer bautechnischen PDF-Zeichnung, erreicht.

Dies ist sehr komfortabel und zugleich besonders präzise. Hierdurch wird also die Mensch-Maschine-Schnittstelle noch weiter verbessert.

Gemäß einer Weiterbildung umfasst das Verfahren ferner einen Schritt eines automatisierten Nummerierens und/oder Bezeichnens von Aufmaßobjekten, insbesondere ferner umfassend eine graphische Darstellung einer Objektnummer und/oder eines Objektbezeichners, insbesondere ein konsekutives automatisches Nummerieren der Aufmaßobjekte je Layerebene, wobei eine Nummer innerhalb einer Layerebene nur jeweils einem eindeutigen Aufmaßobjekt zugeordnet wird.

Dies erhöht die Übersichtlichkeit und die Prüfbarkeit, erlaubt eine unmittelbare Identifikation und/oder Zuordnung und erleichtert zudem die technische Verwaltung der Daten.

Gemäß einer Weiterbildung des Prüfverfahrens umfasst der Unterschritt des Prüfens von Aufmaßgrößen in Bezug auf Aufmaßobjekte der mindestens einen Layerebene ein graphisches Prüfen, insbesondere unter Einblenden einer zu prüfenden Layerebene und Ausblenden mindestens einer anderen Layerebene, insbesondere durch graphisches Prüfen der Layerebene vor der entsprechenden bautechnischen Zeichnung, ferner insbesondere durch graphisches Prüfen der Layerebene vor neutraler Grundierung, beispielsweise weißer Grundierung.

Dies schafft ein benutzerfreundliches User Interface und erhöht die Übersichtlichkeit und damit die Geschwindigkeit als auch die Verlässlichkeit des Prüfprozesses. Es kann insbesondere layerebenenweise geprüft werden. Hierbei ist immer nur eine einzelne layerebenenspezifische Berechnungsvorschrift zu prüfen bzw. zu berücksichtigen, was effizienzsteigernd ist. Im Übrigen wird auf die obige Diskussion der Vorteile im Rahmen des Aufmaßverfahrens und des Computerprogrammes verwiesen.

Für die technischen Vorteile dieser Mensch-Maschine-Schnittstelle wird auf die obige Diskussion hierzu verwiesen.

Die Erfindung schafft einschlägige Verfahren, Computer, Computerprogramme, Computernetzwerke, Daten sowie computerlesbare Datenträger. Die Erfindung oder Teile davon können auch für andere Datenquellen als bautechnische Zeichnungen zum Einsatz kommen. Ein weiteres Anwendungsbeispiel ist die Bildverarbeitung. Beispielsweise könnten Bilder oder Bildausschnitte von Gesichtern (z.B. erkannt durch KI) auf einen Layer gelegt werden. Danach ließen sich entsprechende Regeln festlegen, z.B. dass Gesichter mit Pickeln weichgezeichnet werden.

In einem weiteren Beispiel könnte man in einem CAD-Programm definieren, dass die linearen Bemaßungsobjekte eines Layers in einem bestimmten Maßstab dargestellt werden.

Sämtliche im Zusammenhang mit einer Anspruchskategorie offenbarten Merkmale, beispielsweise im Rahmen des entsprechenden Verfahrens offenbarte Merkmale, können im Zusammenhang mit den anderen Anspruchskategorien, beispielsweise Vorrichtungen und Computerprogrammen, zum Einsatz gebracht werden, als auch umgekehrt. Die Anspruchskategorien entfalten in dieser Hinsicht keinerlei kategorische Beschränkungen für Erfindungsmerkmale. Gleiches gilt für mehrere unabhängige Ansprüche innerhalb derselben Anspruchskategorie, sofern vorhanden.

**Figurenliste**

Die vorliegende Erfindung wird nachfolgend anhand der in den schematischen Figuren der Zeichnungen angegebenen Ausführungsbeispiele näher erläutert. Es zeigen dabei:

Fig. 1 eine schematische Darstellung einer Ausgangsansicht in der Software Veoplan mit einem Leistungsverzeichnis im Rahmen eines Beispielprojektes

Fig. 2 eine schematische Darstellung der Erstellung und Zuordnung eines Layers für die Leistungsposition "39.01.010" zum Aufmaß einer Deckenschürze im Rahmen eines Beispielprojektes

Fig. 3 eine schematische Darstellung der Erstellung und Zuordnung eines Layers für die Leistungsposition "39.01.020" zum Aufmaß von Ausschnitten in einer Deckenschürze im Rahmen eines Beispielprojektes

Fig. 4 eine schematische Darstellung der Erstellung und Zuordnung eines Layers für die Leistungsposition "39.01.040" zum Aufmaß einer (weiteren) Art von Ausschnitten in einer Deckenschürze im Rahmen eines Beispielprojektes

Fig. 5 eine schematische Darstellung der Erstellung und Zuordnung eines Layers für die Leistungsposition "39.01.050" zum Aufmaß einer Rasterdecke (Fläche) im Rahmen eines Beispielprojektes

Fig. 6 eine schematische Darstellung der Erstellung und Zuordnung eines Layers für die Leistungsposition "39.02.150" zum Aufmaß von Metallständerwänden im Rahmen eines Beispielprojektes

Fig. 7 eine schematische Darstellung der Erstellung und Zuordnung eines Layers für die Leistungsposition "39.02.240" zum Aufmaß von Eckschutzschienen im Rahmen eines Beispielprojektes

Fig. 8 eine schematische Darstellung der Erstellung und Zuordnung eines Layers für die Leistungsposition "39.02.270" zum Aufmaß von UA-Profilen für WC-Tragständer im Rahmen eines Beispielprojektes

Fig. 9 eine schematische Darstellung der Zuordnung von definierten Layerebenen zu einer oder mehreren bautechnischen Zeichnungen

Fig. 10a eine schematische Darstellung von Aufmaßobjekten (Polylinien) in einer bautechnischen Zeichnung zum Aufmaß einer Deckenschürze für die Leistungsposition "39.01.010" im Rahmen eines Beispielprojektes

Fig. 10b eine schematische Darstellung von Aufmaßobjekten (Polylinien) samt Objektnummern ohne die bautechnische Zeichnung zum Aufmaß einer Deckenschürze für die Leistungsposition "39.01.010" im Rahmen eines Beispielprojektes

Fig. 11 eine schematische Darstellung von Aufmaßobjekten (Ovalen) in einer bautechnischen Zeichnung zum Aufmaß von Ausschnitten in einer Deckenschürze für die Leistungsposition "39.01.020" im Rahmen eines Beispielprojektes

Fig. 12 eine schematische Darstellung von Aufmaßobjekten (Freitext) in einer bautechnischen Zeichnung zum Aufmaß einer (weiteren) Art von Ausschnitten in einer Deckenschürze für die Leistungsposition "39.01.040" im Rahmen eines Beispielprojektes

Fig. 13 eine schematische Darstellung von Aufmaßobjekten (Polygone) in einer bautechnischen Zeichnung zum Aufmaß einer Rasterdecke (Fläche) für die Leistungsposition "39.01.050" im Rahmen eines Beispielprojektes

Fig. 14 eine schematische Darstellung von Aufmaßobjekten (Polylinien) in einer bautechnischen Zeichnung zum Aufmaß von Metallständerwänden für die Leistungsposition "39.02.150" im Rahmen eines Beispielprojektes unter Anwendung einer layerebenenspezifischen Formel

Fig. 15 eine schematische Darstellung von Aufmaßobjekten (Ovale) in einer bautechnischen Zeichnung zum Aufmaß von Eckschutzschienen für die Leistungsposition "39.02.240" im Rahmen eines Beispielprojektes unter Anwendung einer layerebenenspezifischen Formel

Fig. 16 eine schematische Darstellung von Aufmaßobjekten (Rechtecke) in einer bautechnischen Zeichnung zum Aufmaß von UA-Profilen für WC-Tragständer für die Leistungsposition "39.02.270" im Rahmen eines Beispielprojektes unter Anwendung einer layerebenenspezifischen Formel

Fig. 17 eine schematische Darstellung eines Aufmaßdokuments, erstellt mit der Software Veoplan, im Rahmen eines Beispielprojekts

Fig. 18 eine schematische Darstellung von Aufmaßobjekten samt Objektnummern (insgesamt vier Positionen)

Fig. 19 eine schematische Darstellung von Aufmaßobjekten samt Objektnummern (nur zwei Positionen)

Fig. 20 eine schematische Darstellung einer Rechnung, erstellt mit der Software Veoplan, im Rahmen eines Beispielprojekts

Fig. 21 eine schematische Darstellung von Aufmaßobjekten unter Ausblendung einer bautechnischen Zeichnung im Rahmen eines Beispielprojektes [sämtliche Aufmaßobjekte]

Fig. 22 eine schematische Darstellung von Aufmaßobjekten unter Ausblendung einer bautechnischen Zeichnung im Rahmen eines Beispielprojektes [nur Metallständerwand, Positionsnummer 39.02.150]

Fig. 23a-d schematische Darstellungen beispielhafter Layerstrukturen für den Einsatz in Ausführungsformen der vorliegenden Erfindung

Fig. 24a eine schematische Darstellung eines Leistungsverzeichnisses samt Aufmaß aus dem Stand der Technik

Fig. 24b,c schematische Darstellungen hierzu passender bautechnischer Zeichnungen aus dem Stand der Technik.

In allen Figuren sind gleiche bzw. funktionsgleiche Elemente und Vorrichtungen - sofern nichts anderes angegeben ist - mit denselben Bezugszeichen versehen worden.

**Beschreibung der Zeichnungen**

Die Erfindung wird, in nicht beschränkender Weise, anhand der hauseigen entwickelten Software "VEOPLAN" des Anmelders im Folgenden weiter beschrieben.

Zu diesem Zwecke wurde, zur Erleichterung der Recherche und der Patentprüfung, ein kleines, übersichtliches, fiktives Beispielprojekt in VEOPLAN erstellt. Dieses Projekt dient zur Verdeutlichung und Erläuterung der Prinzipien. Es werden hierzu ein zweiseitiges Aufmaßdokument und eine einseitige finale Rechnung vorgestellt.

Es sei darauf hingewiesen, dass Aufmaße echter Bauprojekte realistischerweise mehrere hundert oder gar tausende Seiten umfassen und der Fortschritt der Bauprojekte mehrmals zwischenaufgemessen und zwischenabgerechnet wird.

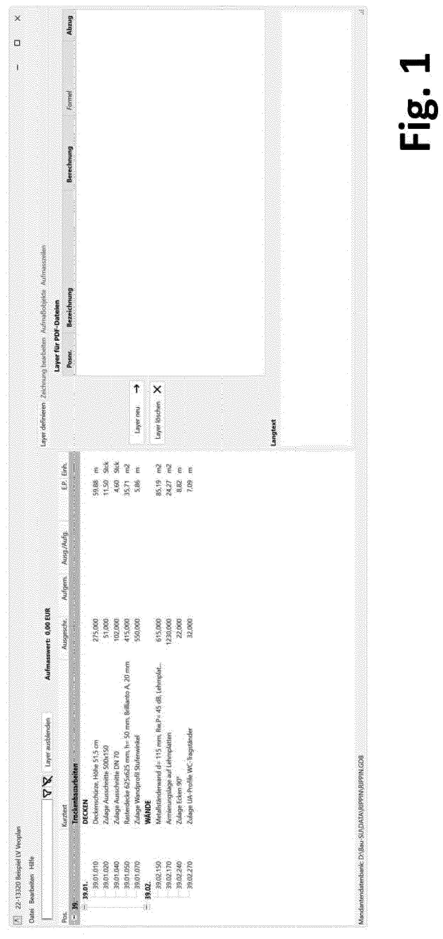

In der Figur 1 ist eine Ausgangsansicht in der Software Veoplan zu sehen. In der linken Hälfte ist ein beispielhaftes Leistungsverzeichnis zu sehen. Ein Aufmaß wird hierfür nun sukzessive vorgenommen.

In einer Spalte mit dem Titel "Ausgeschr." sind bereits die ausgeschriebenen Mengen der Leistungspositionen zu sehen. Unter Nutzung von Veoplan werden die aufgemessenen Mengen ermittelt und werden sodann in der Spalte mit dem Titel "Aufgem." wiedergegeben. Ein Quotient der Mengen kann berechnet werden und wird in der Spalte "Aufg./Ausg." dargestellt werden. Dies kann beispielsweise in Form eines Balkendiagrammes erfolgen. Beispielsweise sind bei 100% die aufgemessene und die ausgeschriebene Menge einer Leistungsposition identisch. Bei 20% wurde nur 1/5 der Menge aufgemessen, welche ausgeschrieben wurde. Beispielsweise wurden so nur 20% der ursprünglich geplanten (ausgeschriebenen) Material- und/oder Leistungsmenge benötigt.

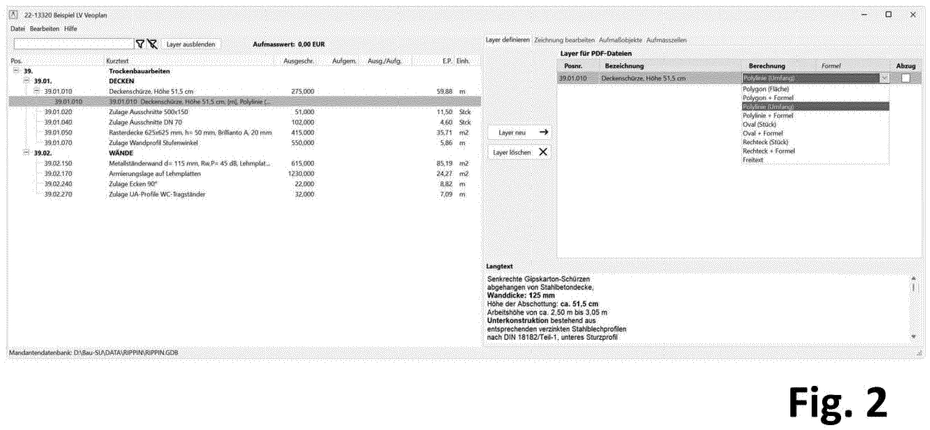

Für die einzelnen Leistungspositionen können in Veoplan ein oder mehrere Layer erstellt werden. Dies ist in der Figur 2 beispielhaft dargestellt: Für die Leistungsposition "39.01.010" mit dem Kurztext "Deckenschürze, Höhe 51,5 cm" wird ein neuer Layer (eine neue Layerebene) erstellt. Eine layerebenenspezifische Berechnungsvorschrift kann definiert werden durch die Spalten "Berechnung" und (ggf.) unter Zuhilfenahme der Spalte "Formel".

Auf der linken Seite ist der neue Layer durch einen neuen Eintrag (dargestellt in blauer Schrift) zu sehen, welcher der Leistungsposition zugeordnet ist. Der neue Layer wird auch auf der rechten Seite dargestellt, wo sich Einstellungen zum Layer vornehmen lassen.

Die Deckenschürze der Figur 2 soll als Länge, in Meter [m], aufgemessen werden. Als Aufmaßobjekte werden zu diesem Zwecke in diesem Beispiel Polylinien eingesetzt. Daher erfolgt eine Auswahl "Polylinie (Umfang)". In diesem, bewusst sehr einfach gewählten, Beispiel bleibt die Spalte "Formel" also zunächst ungenutzt. Die Deckenschürze soll also durch Polylinien aufmessen werden, und das relevante Aufmaß ist die jeweilige Länge/der Umfang der Polylinie. An späterer Stelle werden komplexere layerebenenspezifische Berechnungsvorschriften vorgestellt werden. In diesem Beispiel hier wird lediglich die Gesamtlänge/der Umfang einer Polylinie (Aufmaßobjekt) bestimmt und diese Länge wird beispielsweise in ein Aufmaßgrößenresultat übernommen.

Die Erfindung zeichnet sich unter anderem dadurch aus, dass sie layerebenenspezifische Berechnungsvorschriften ermöglicht und gewinnbringend nutzt. Der Begriff Layer bzw. Layerebene ist dabei im Kontext dieser Erfindung keineswegs auf eine graphische Lösung beschränkt, sondern vielmehr als logische Einheit zu verstehen. Es wird jedoch im Rahmen dieser Erfindung immer der Begriff "Layer" oder "Layerebene" benutzt werden, da eine graphisch-logische Vorstellung eines Layers eine sehr anschauliche Variante der vorliegenden Erfindung darstellt. Die Erfindung möchte sich jedoch keineswegs auf eine solche, zu enge Auslegung des Begriffes "Layer" beschränken. Beispielsweise kann es auch eine rein logische Struktur und/oder Gruppierung sein, ohne dass notwendigerweise eine unmittelbare graphische Darstellung in Form einer oder mehrere sich überlagernder Ebenen ("Layer" im engerem Sinne) darstellt. In anderen Worten können "Layer" oder "Layerebenen" durch verschiedenste logische Strukturen geschaffen werden. Diese Strukturen können lediglich beispielhaft als sich überlagernde Ebenen visualisiert werden.

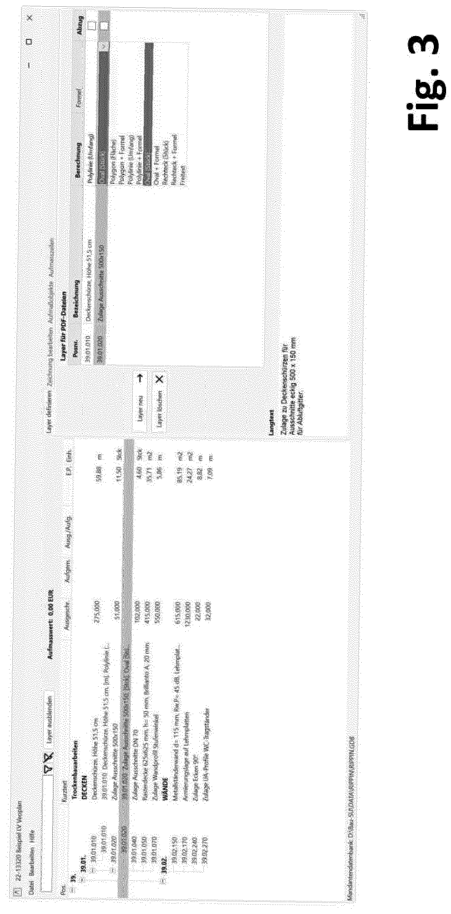

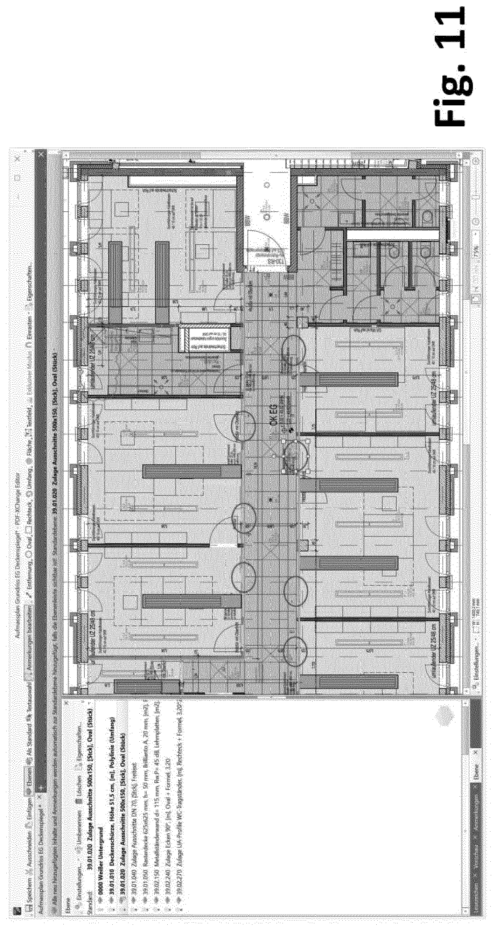

In der Figur 3 wird ein Layer für eine weitere Leistungsposition erstellt. Diese Leistungsposition für "Zulage Ausschnitte" wird in Stückzahlen aufgemessen und durch Ovale symbolisiert. (Die Form/Größe der Ovale spielt hierbei keine Rolle, sondern lediglich die Stückzahl. Siehe auch die Diskussion zur Figur 11 weiter unten.) Ein Oval wird also beispielsweise mit dem Gewicht "1" beispielsweise in ein Aufmaßgrößenresultat übernommen. Auch in diesem Beispiel bleibt das Feld "Formel" ungenutzt. Es sei erwähnt, dass auch dieses Beispiel für eine layerebenenspezifische Berechnungsvorschrift bewusst sehr einfach gewählt ist. Kompliziertere bzw. komplexere Beispiele werden anhand noch folgender Figurenbeschreibungen erbracht. Entscheidend und bereits hier klar erkennbar ist jedoch die Möglichkeit, für eine Layerebene eine zugrundeliegende Berechnungsvorschrift zu definieren, einzustellen und modifizieren zu können. Die Berechnungsvorschrift ist dabei layerebenenspezifisch und muss für eine Layerebene nur an einer Stelle eingestellt bzw. eingegeben werden. Veoplan übernimmt sodann die Anwendung der layerebenenspezifischen Berechnungsvorschrift auf sämtliche in der jeweiligen Layerebene vorhandenen Aufmaßobjekte zwecks komfortabler Vornahme und Berechnung des korrekten Aufmaßes in der gewünschten Form. Beispielsweise wird als Output eine aufgemessene Gesamtmenge für eine Leistungsposition bereitgestellt. Das kann beispielsweise eine Leistungsposition sein, welche in Meter, in Stückzahlen, Quadratmeter oder auch anderen Maßen aufgemessen bzw. abgerechnet wird. Die Erfindung ist diesbezüglich insbesondere nicht limitiert.

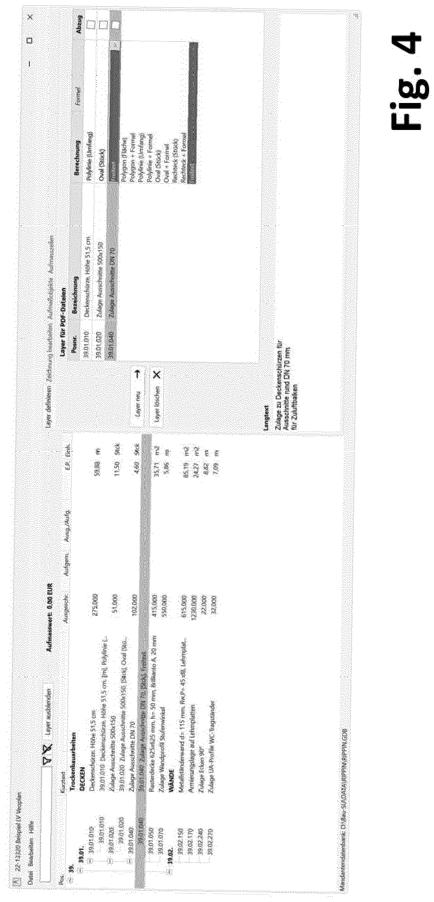

In der Figur 4 wird eine weitere Layerebene hinzugefügt, um eine Leistungsposition "Zulage Ausschnitte" aufzumessen. In Veoplan wird hier ein Aufmaßobjekt vom Typ "Freitext" eingesetzt. (Diese Variante von Veoplan ist keineswegs limitierend für die Erfindung, und lediglich ein Beispiel für eine Umsetzung.) In diesem Freitext-Objekt, welches Veoplan bereitstellt, kann beispielsweise eine beliebig komplizierte mathematische Formel eingegeben werden, z.B. "2,34*3,20 - (2,10 - 0,55)*2". Veoplan vermag solche Formeln auszuwerten.

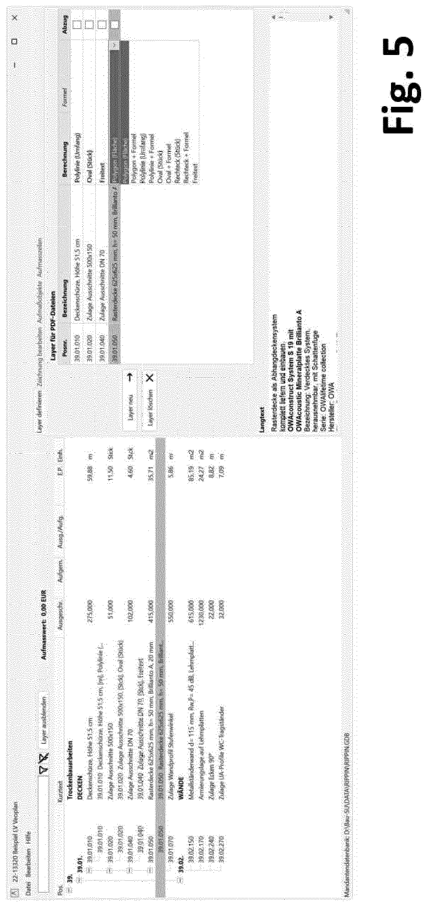

In der Figur 5 wird eine weitere Layerebene hinzugefügt, um eine Leistungsposition für eine Rasterdecke aufzumessen. Dies geschieht unter Nutzung von Polygonen als Aufmaßobjekte. Das Aufmaß der Rasterdecke erfolgt nach Fläche. Dabei wird also die Fläche der Polygone bestimmt. Ein Polygon muss aus mindestens drei Koordinatenpunkten bestehen, damit die Fläche korrekt berechnet und aufgemessen werden kann.

Ein Maßstab einer bautechnischen Zeichnung entweder beispielsweise automatisch erkannt oder vom Benutzer vorgegeben werden. Ein üblicher Wert ist 1:50. Beispielsweise ist auch ein voreingesteller Wert, z.B. 1:50, in Veoplan vorgegeben, und kann vom Nutzer bei Bedarf angepasst werden. Zudem werden beim graphischen Aufmessen (z.B. dem Erstellen der Aufmaßobjekte an einem PC mit Maus und Tastatur) Fangpunkte benutzt. Dies liefert exakte Ergebnisse, da layerebenenspezifische Berechnungsvorschriften so auf exakte Größen (Aufmaßgrößen) der erstellten Aufmaßobjekte angewandt werden. Das resultierende Aufmaß ist so numerisch exakt, insbesondere in Bezug auf die bautechnische Zeichnung.

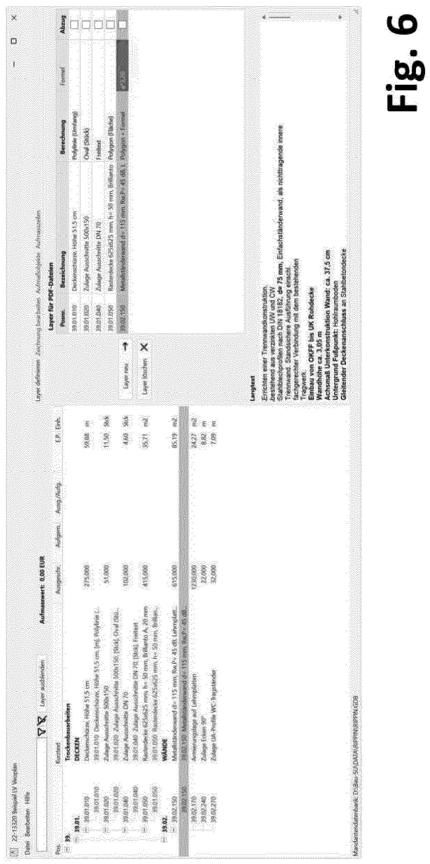

In der Figur 6 wird eine weitere Layerebene hinzugefügt, um eine Leistungsposition für eine Metallständerwand aufzumessen. Hier wird eine Berechnungsregel "Polylinie + Formel" zum Einsatz gebracht. Es wird eine Formel definiert, hier beispielsweise als "a*3,20", wobei a die Gesamtlänge der Polylinie repräsentiert. Sollte die Gesamtlänge einer Polylinie beispielsweise 5,67 m sein, so wird diese mit 3,20 multipliziert und geht mit dem Ergebnis (18,144) beispielsweise in ein Aufmaßgrößenresultat ein. Die layerebenenspezifische Berechnungsvorschrift ist hier beispielsweise durch "nimm die Länge der Polylinie und gewichte sie mit 3,20" gegeben. (Die Gründe für eine solche Gewichtung können freilich vielfältig sein, und die Erfindung legt sich hierbei keineswegs fest. Lediglich in einem Beispiel ist die Wand 3,20m hoch und soll nach Fläche der verbauten Wand abgerechnet werden.)

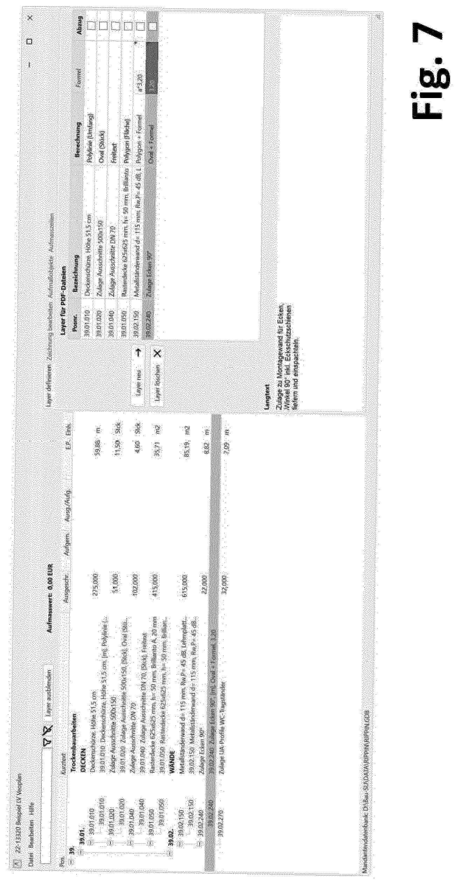

In der Figur 7 wird eine weitere Layerebene hinzugefügt. Hier haben wir es mit Aufmaßobjekten des Types "Oval", jedoch mit Formel, zu tun. Es kann eine Formel eingegeben werden. Diese Formel wird ausgewertet. Jedes Aufmaßobjekt "Oval" geht gemäß dieser layerebenenspezifischen Berechnungsvorschrift mit dem Gewicht/dem Ergebnis dieser Formel ein. In diesem Beispiel wurde ein fester Wert von 3,20 pro Oval definiert und wird so in das Aufmaß übernommen.

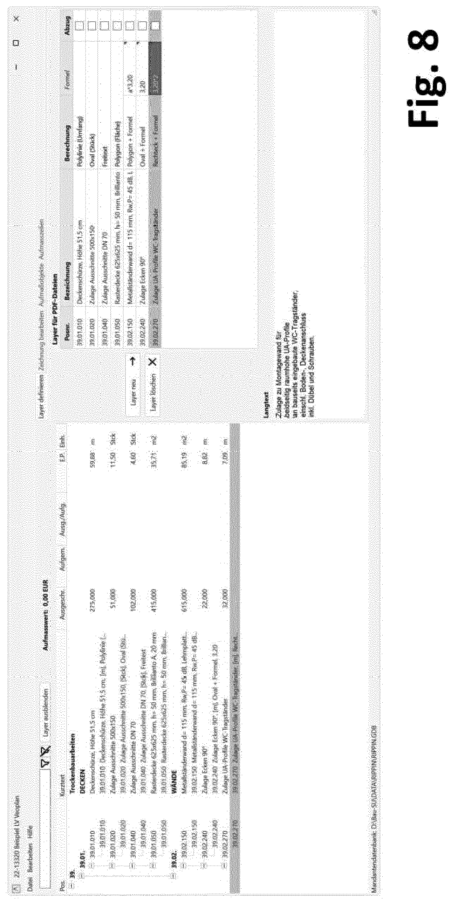

In der Figur 8 wird eine weitere Layerebene hinzugefügt. Hier kommen Aufmaßobjekte des Typs "Rechteck" zum Einsatz, ebenfalls ergänzt durch eine Formel.

An diesem Beispiel wird deutlich, dass beispielsweise auch verschiedene Aufmaßobjekte zum Einsatz gebracht werden können, welche sich lediglich durch ihr visuelles Aussehen im Plan unterscheiden (hier: jetzt Rechtecke statt wie zuvor Ovale).

Hier wurde als Formel "3,20*2" gewählt. So geht, in diesem Beispiel jedes Rechteck mit dem Ergebnis der Formel als Gewicht (hier 6,40) beispielsweise in ein Aufmaßgrößenresultat ein.

Die layerebenenspezifische Berechnungsvorschrift könnte in diesem Beispiel als "gewichte jedes Rechteck in dieser Layerebene für das Aufmaß mit dem Ergebnis von 3,20*2" aufgefasst werden.

Die Gründe für derartige Formeln können vielseitig sein, und die Erfindung möchte sich in dieser Hinsicht keineswegs beschränken. In diesem Beispiel ist der Raum 3,20 m hoch und es sollen nach Länge sogenannte UA-Profile (für WC-Tragständer) abgerechnet werden.

Von diesen UA-Profilen werden für ein einziges WC (eine Toilette) zwei parallel im Hohlraum einer Wand angeordnet, um das WC zu tragen. Daher ist der Faktor 2 gerechtfertigt, und es ist sehr hilfreich, dass er mittels Veoplan in dieser Weise in die layerebenenspezifische Berechnungsvorschrift eingebracht werden kann.

Beispielsweise ist dieses Ergebnis auch daher besonders gut später nachvollziehbar und leicht prüfbar, da mit der Formel "3,20*2" gearbeitet wird, und nicht nur direkt mit einem Zwischenergebnis "6,40".

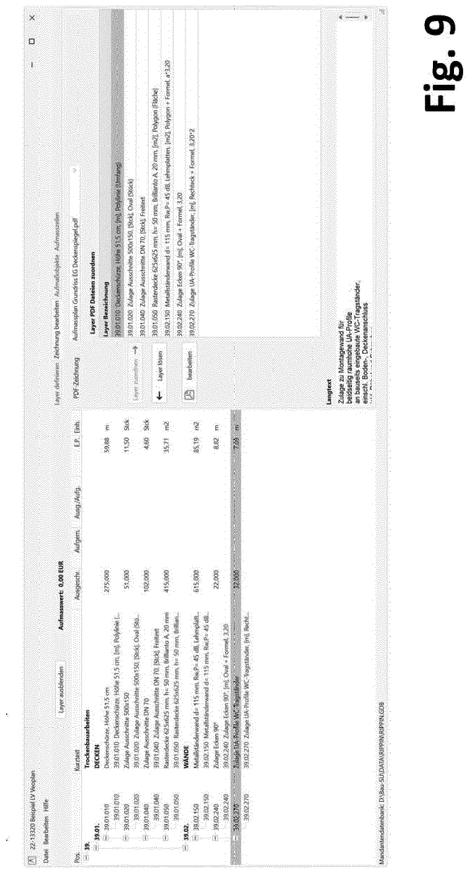

In der Figur 9 wurden die definierten Layerebenen einem (oder mehreren) Bauplänen/bautechnischen Zeichnungen zugeordnet. Die Layerebenen stehen daher ab sofort in diesen Zeichnungen zur Verfügung. In diesem Beispiel im Rahmen des Beispielprojekts demonstrieren wir die Erfindung der Einfachheit und Übersichtlichkeit halber zudem nur mit einem einzigen Bauplan/einer einzigen bautechnischen Zeichnung.

Es folgen nun einige Beispielansichten von bereits aufgemessenen Objekten samt den hierfür vergebenen Objektnummern. Die Ansichten sind lediglich beispielhaft und keineswegs beschränkend für die Erfindung. Es wird jedoch klar, wie sehr der Gebrauch der Erfindung auch den Prüfprozess erleichtert, da auf die Layerebenen - einschließlich graphischer Ansichten dieser - und die layerebenenspezifischen Berechnungsvorschriften zurückgegriffen werden kann.

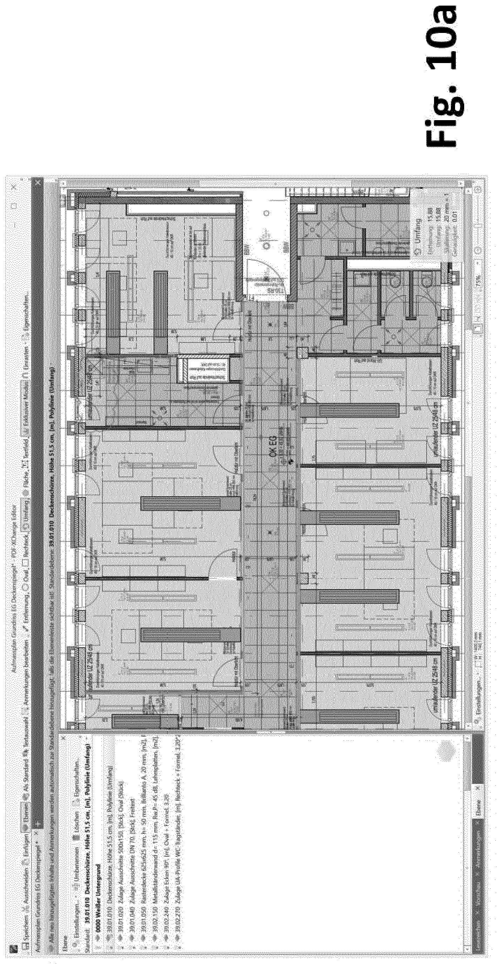

In der Figur 10a werden zur Leistungsposition "39.01.010" des Beispielprojekts die Aufmaßobjekte dargestellt (grüne Farbe). Die Aufmaßobjekte sind Polylinien. Objektnummern wurden vergeben, welche eine Zuordnung/einen Abgleich mit einem Leistungsverzeichnis, einem Aufmaßdokument oder einer Rechnung ermöglichen. Die Objektnummer werden beispielsweise pro Layerebene in aufsteigender Reihenfolge den hierin enthaltenen Aufmaßobjekten zugeordnet. Die Darstellung der Objektnummern ist optional. Auch kann der Zeitpunkt unterschiedlich sein, zu welchem die Objektnummern vergeben und/oder dargestellt werden. In der Figur 10a wurden die Objektnummern noch nicht vergeben und daher sind diese nicht dargestellt. Eine Variante mit dargestellten Objektnummern ist jedenfalls bevorzugt, da sie eine schnelle Zuordnung zu in Leistungspositionen aufgeführten Aufmaßzeilen ermöglicht.

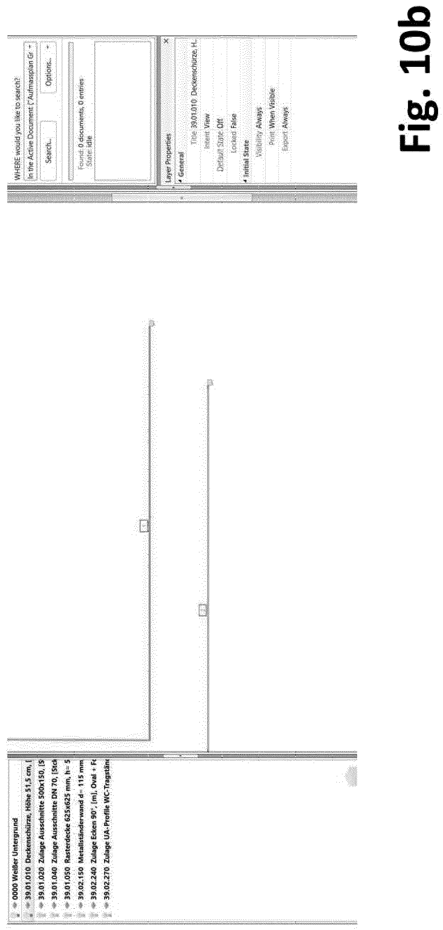

Um die gute Übersichtlichkeit noch weiter zu erhöhen bzw. um die Aufmaßobjekte noch schneller zu finden, besteht die Möglichkeit, mit nur einem Klick eine Layerebene auf weißen/neutralen Untergrund zu projizieren (d.h. insbesondere die bautechnische Zeichnung selbst auszublenden). Dies ist in Figur 10b dargestellt. Sehr leicht sind für den Betrachter die beiden Polylinien "1" und "2" (Objektnummern) für die Deckenschürzen verifizierbar. Mit nur einem weiteren Klick wird der Bauplan wieder eingeblendet. So kann in enormer Schnelle der Kontext dieser Aufmaßobjekte und damit die Akkuratheit des vorgenommenen Aufmaßes überprüft werden.

In der Figur 11 kommen die Ausschnitte in der Deckenschürze (Leistungsposition 39.01.020) in Form von Ovalen als Aufmaßobjekte hinzu. Aufgemessen wird hier die Anzahl der Ausschnitte (rote Ovale).

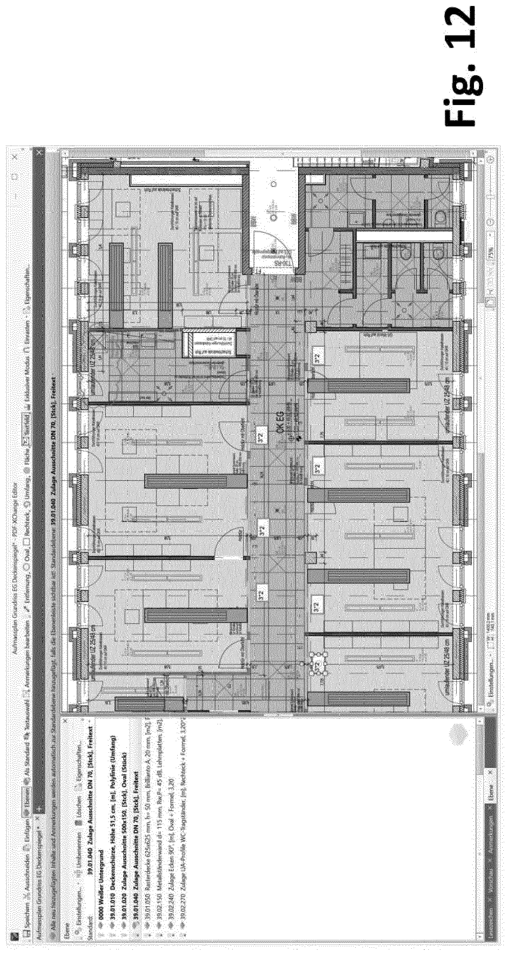

In der Figur 12 wird zur Leistungsposition 39.01.040 die Anzahl der Ausschnitte in der Deckschürze mit dem Aufmaßobjekt "Freitext" aufgemessen. Jedes Aufmaßobjekt enthält die Berechnungsformel "3*2". Als Aufmaßgrößenresultat wird also 6 in das Aufmaß übernommen.

Die Layer für die Positionen 39.01.010 und 39.01.20 wurden ausgeblendet, um die Übersicht zu verbessern.

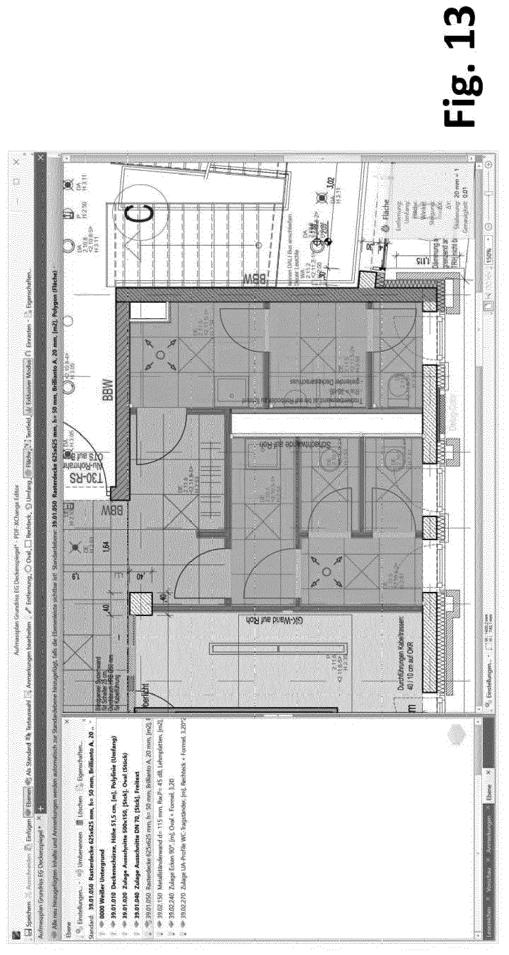

In der Figur 13 wird zur Leistungsposition 39.01.050 die Fläche der Rasterdecke mit dem Aufmaßobjekt "Polygon" aufgemessen (grüne Fläche). Jedes Aufmaßobjekt enthält den Flächeninhalt. Als Aufmaßgröße wird der Flächeninhalt in das Aufmaß übernommen.

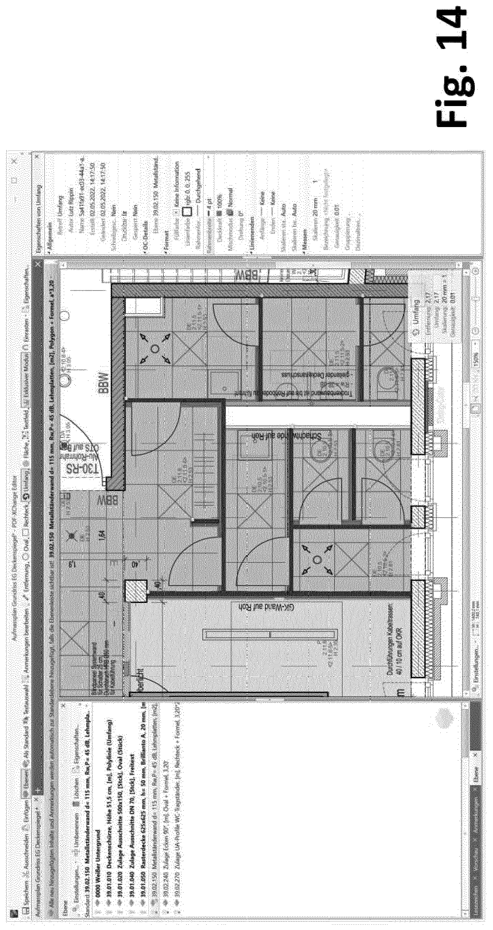

In der Figur 14 wird zur Leistungsposition 39.01.150 die Fläche der Metallständerwände mit dem Aufmaßobjekt "Polylinie" aufgemessen (blaue Linien). Jedes Aufmaßobjekt enthält die Strecke der Polylinie (Aufmaßgröße a). Veoplan berechnet aus dieser Strecke und der Berechnungsformel für den Layer ("a*3,20") das Aufmaßgrößenresultat. Es wird der berechnete Flächeninhalt in das Aufmaß übernommen.

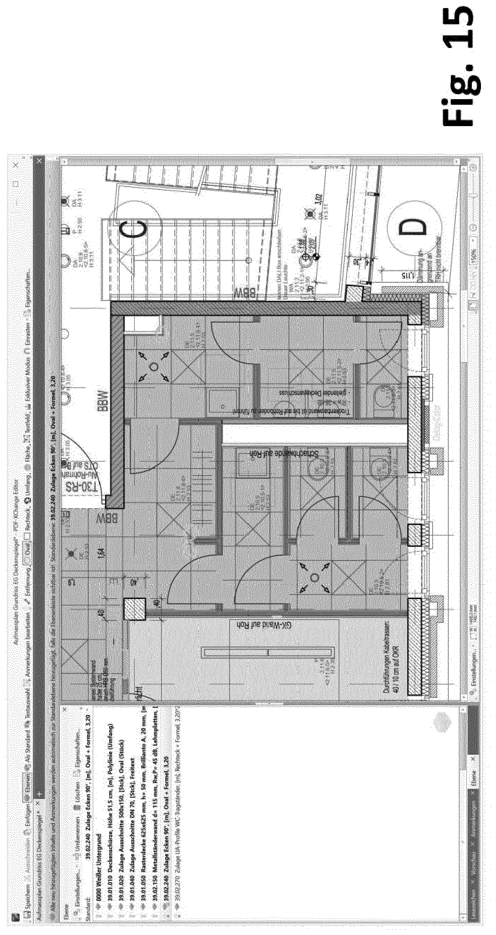

In der Figur 15 wird zur Leistungsposition 39.02.240 die Länge der Eckschutzschienen mit dem Aufmaßobjekt "Oval" aufgemessen (hellgrün). Jedes Aufmaßobjekt wird nur als Anzahl 1 ausgewertet. Veoplan berechnet aus der Berechnungsformel für den Layer ("3,20") das Aufmaßgrößenresultat. Es wird die berechnete Strecke (pro Oval 3,20m) in das Aufmaß übernommen.

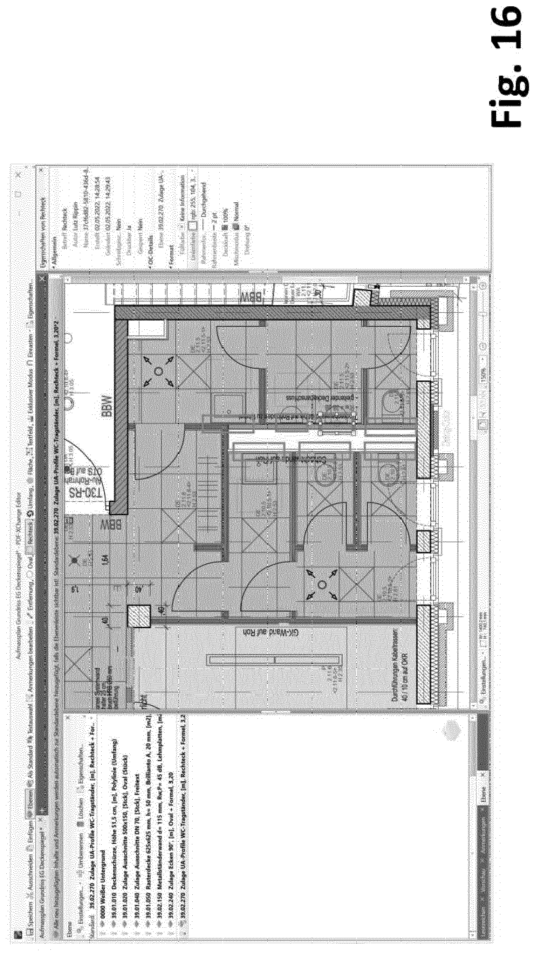

In der Figur 16 wird zur Leistungsposition 39.02.270 die Länge der UA-Profile mit dem Aufmassobjekt "Rechteck" aufgemessen (orange). Jedes Aufmaßobjekt wird nur als Anzahl 1 ausgewertet. Veoplan berechnet aus der Berechnungsformel für den Layer ("3,20*2") das Aufmaßresultat. Es wird die berechnete Strecke (pro Rechteck 6,40m) in das Aufmaß übernommen. Bei den UA-Profilen werden pro Aufmaßobjekt in diesem Beispiel zwei Profile benötigt von je 3,20m Länge. Es werde in diesem Beispielprojekt in der späteren Rechnung bzw. dem Aufmaßdokument sowohl "3,20*2" im Feld "Rechenoperation" als auch das Ergebnis "6,40" im Feld "Menge" ausgewiesen. Dies erhöht die Prüfbarkeit und Nachvollziehbarkeit des Aufmaßes enorm.

Layerebenenspezifische Berechnungsvorschriften erlauben allerlei mathematische Operationen. In einem weiteren Beispiel findet eine Division statt, gefolgt von einer Aufrundeoperation. Beispielsweise soll alle 0,33 Meter einer Polylinie ein bestimmter Ständer aufgestellt werden. Es werden jedoch auch Ständer an den Endpunkten benötigt. Die Zahl der benötigten Ständer kann sich so aus einer Formel

```
Aufrunden(a/0,33)+1
```

ergeben, wobei "Aufrunden" ein Aufrunden auf die nächste ganze Zahl bezeichnet und / eine (Gleitkomma-)Division.

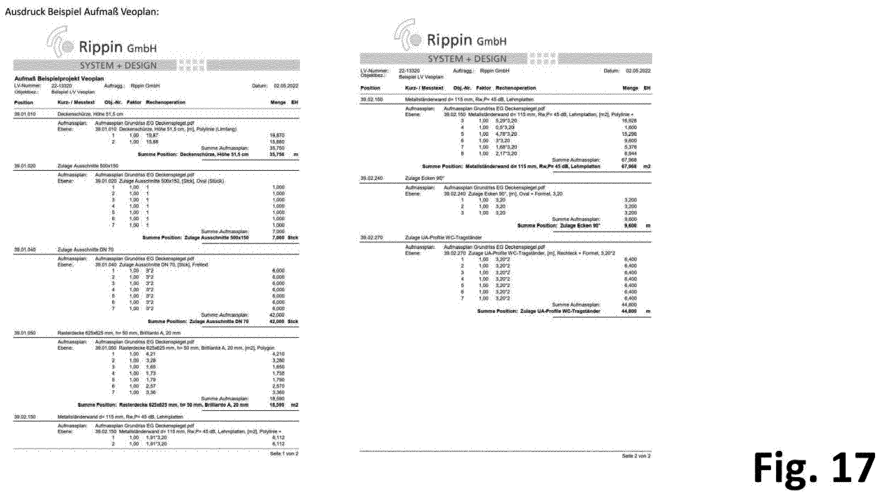

Die Figur 17 zeigt das Aufmaßdokument aus Veoplan.

In einer beispielhaften Ausführungsform werden erst nach einem Schließen eines Dokuments einer bautechnischen Zeichnung bzw. nach der Vornahme eines Aufmaßes durch Erstellung von entsprechenden Aufmaßobjekten ("Bearbeitungs- bzw. Aufmaßmodus") die erstellten Aufmaßobjekte gemäß ihrer Layerdefinition (ihrer layerebenenspezifischen Berechnungsvorschrift) berechnet bzw. weiterverarbeitet und mit Objektnummern durchnummeriert.

Der Plan wird mit der Objektnummer des jeweiligen Aufmaßobjekts ergänzt.

Für die Prüfung des Aufmaßes ist somit eine eindeutige Zuordnung zwischen Aufmaßzeile, Objektnummer, Layer und Plan gegeben.

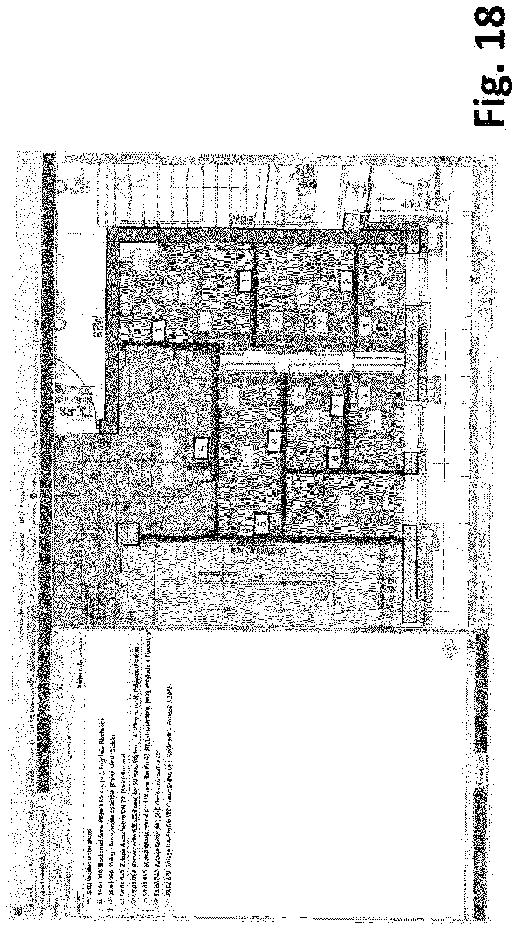

Die Figur 18 zeigt hierzu einen Ausschnitt der bautechnischen Zeichnung des Beispielprojekts unter Anzeige der vergebenen Objektnummern.

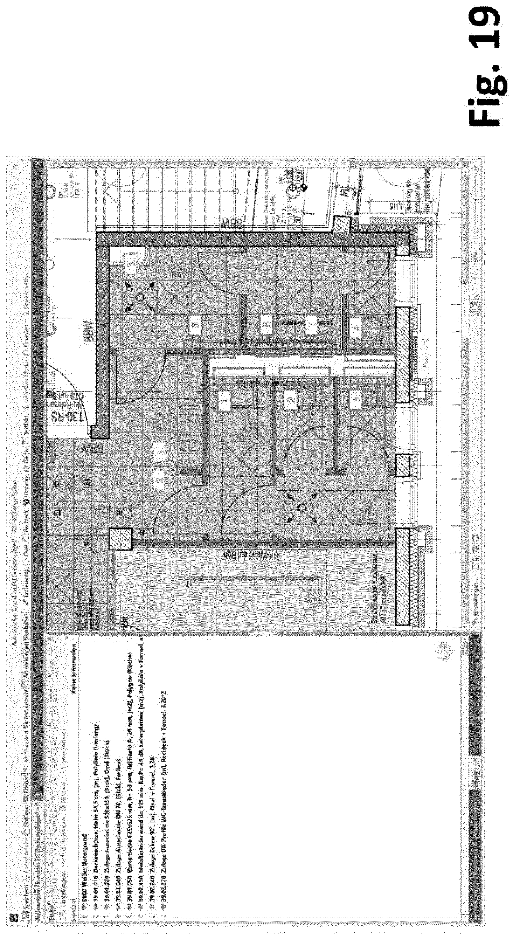

Mittels der Figur 19 wird demonstriert, wie durch das Ein- und Ausblenden von Layerebenen die Übersichtlichkeit erhalten bleibt.

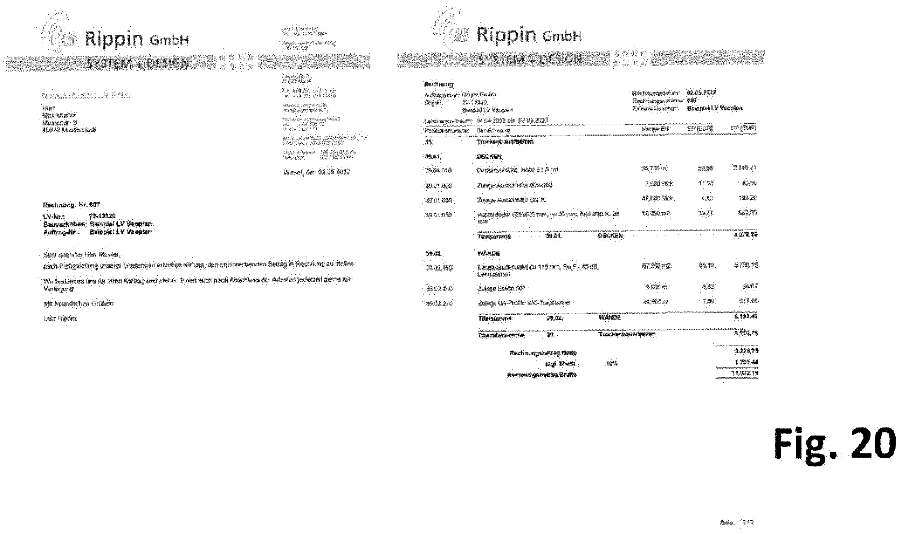

Die Figur 20 zeigt eine Rechnung zum Beispielprojekt, welche auf Basis des mittels Veoplan vorgenommenen Aufmaßes erstellt wurde.

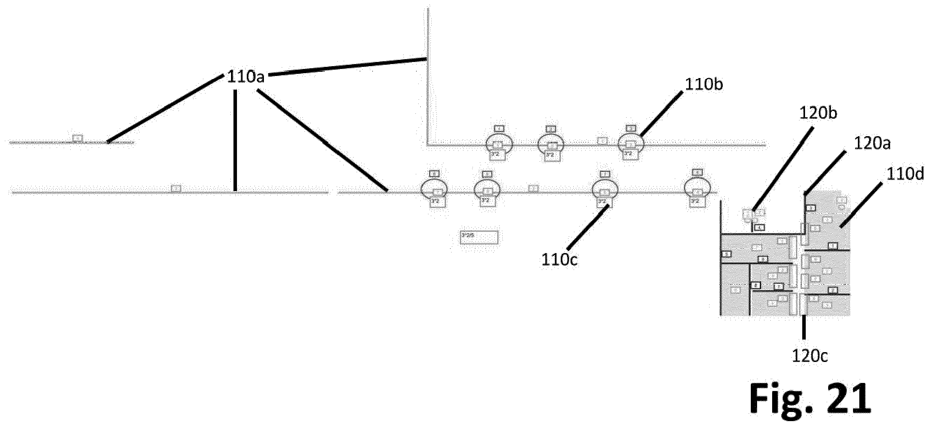

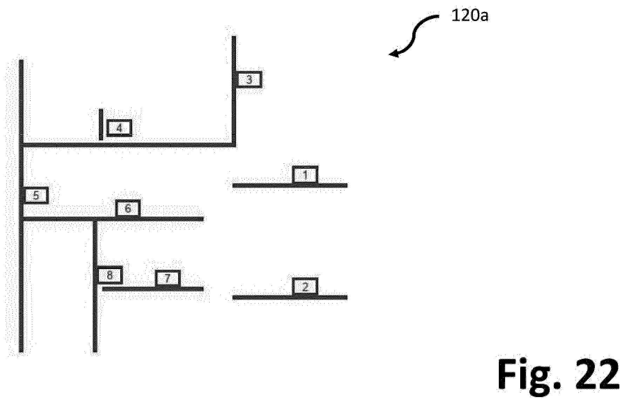

Die Übersichtlichkeit wird weiter demonstriert anhand der folgenden Figuren: In der Figur 21 werden sämtliche Aufmaßobjekte der Leistungspositionen des Beispielprojektes vor neutralem/weißen Grund gezeigt. In der Figur 22 zeigen wir nur die Metallständerwände, welche bereits anhand der Figur 14 diskutiert wurden.

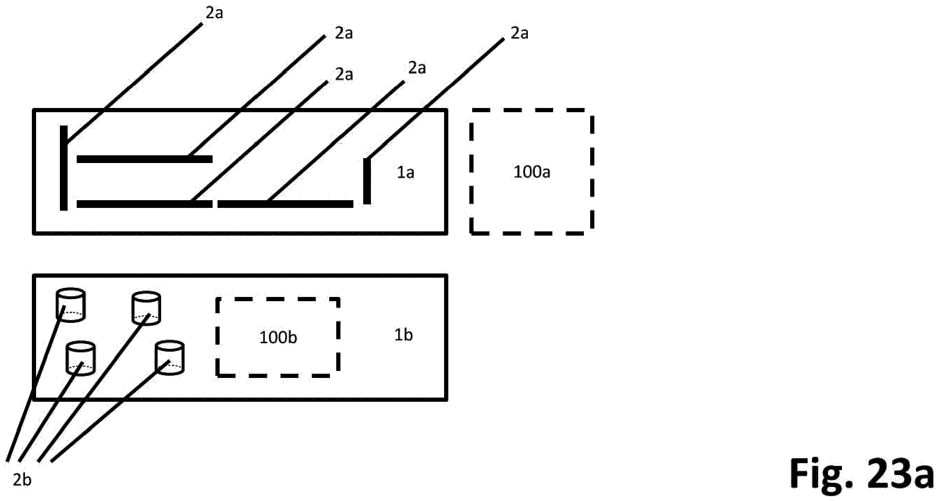

Die Figuren 23a-d verdeutlichen die Layerebenen und insbesondere die Wirkweise der layerebenenspezifischen Berechnungsvorschriften im Rahmen einer bzw. mehrerer Ausführungsformen der vorliegenden Erfindung.

Die Figur 23a zeigt zwei beispielhafte Layerebenen 1a, 1b. Der Layerebene 1a sind Aufmaßobjekte 2a zugeordnet. Der Layerebene 1b sind Aufmaßobjekte 2b zugeordnet. Die Aufmaßobjekte einer Layerebene sind beispielsweise jeweils eines gleichen Types, wie hier graphisch angedeutet wird. Aus den Aufmaßobjekten können beispielsweise Aufmaßgrößen abgeleitet werden. Beispielsweise wird aus einem der Aufmaßobjekte 2a eine Aufmaßgröße "1,80m" abgeleitet, weil das Aufmaßobjekt (unter Berücksichtigung des Maßstabes der bautechnischen Zeichnung) 1,80 Gesamtlänge aufweist.

Eine layerebenenspezifische Berechnungsvorschrift 100a, 100b kann jeder der Layerebenen zugeordnet werden. Diese layerebenenspezifischen Berechnungsvorschriften 100a, 100b sind wichtig für die Berechnung des Aufmaßes aus den Aufmaßgrößen in den jeweiligen Layern unter Erhalt von Aufmaßgrößenresultaten. Letztere sind beispielsweise Mengen, welche in einer Rechnung abzurechnen sind.

Die layerebenenspezifischen Berechnungsvorschriften 100a, 100b sind der jeweiligen Layerebene 1a, 1b zugeordnet. Erstere können in diesem Zusammenhang beispielsweise in der jeweiligen Layerebene direkt enthalten sein (100b), beispielsweise auch direkt innerhalb der Layerebene auf die Aufmaßgrößen der Layerebene angewandt werden, insbesondere unter Nutzung von internen Berechnungsfunktionen zeitgemäßer PDF-Viewer implementiert. Dies muss jedoch nicht der Fall sein. Auch eine externe Berechnung ist möglich. Die Berechnungsvorschrift, welche einer Layerebene zugeordnet ist, kann sich auch außerhalb der Layerebene befinden, wie es hier durch das Beispiel 100a verdeutlicht ist. In einem weiteren Beispiel kann die layerebenenspezifische Berechnungsvorschrift teilweise in der Layerebene und teilweise außerhalb dieser angewandt werden und/oder sich dort befinden. Die Erfindung ist hier keineswegs limitiert.

Durch die in der Figur 23a angedeutete Grundstruktur im Rahmen der vorliegenden Erfindung nimmt, wie sich auch anhand der bereits diskutierten als auch der folgenden Figuren näher zeigen wird, die Bedienbarkeit und Prüfbarkeit zu, es werden manuelle Eingaben als auch manuelle Prüfschritte reduziert und es werden technische Ressourcen (Speicher, Rechenzeit) Erfindung gespart. Auch Fehlerwahrscheinlichkeiten werden reduziert.

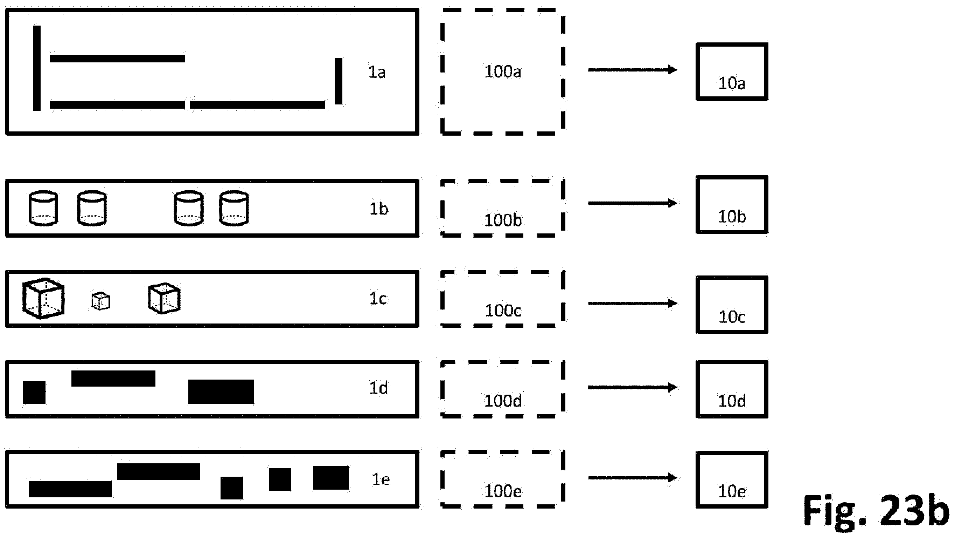

Die Figur 23b verdeutlicht, wie aus verschiedenen Aufmaßobjekten Aufmaßgrößen resultieren, welche sodann erfindungsgemäß mit der der jeweiligen Layerebene entsprechenden layerebenenspezifischen Berechnungsvorschrift 100a-e weiterverarbeitet werden. Dabei entstehen Aufmaßgrößenresultate 10a-e. So ein Aufmaßgrößenresultat wird bereits durch Anwendung einer layerebenenspezifischen Berechnungsvorschrift auf eine einzelne Aufmaßgröße einer Layerebene erzeugt. Es können jedoch weitere Berechnungsschritte vorgesehen sein. Die Erfindung ist hier keineswegs limitiert. Insbesondere ist auch die Summe von Aufmaßgrößenresultaten einer Layerebene ebenfalls ein Aufmaßgrößenresultat. Ein Aufmaßgrößenresultat ist beispielsweise in diesem Sinne jede Größe, welche unter Verwendung einer Aufmaßgröße und/oder eines anderen Aufmaßgrößenresultats erzeugt wurde.

Bezugnehmend auf die Figur 23a kann die Anwendung der Berechnungsvorschrift 100a auf eine Aufmaßgröße eines der Aufmaßobjekte 2a bereits ein Aufmaßgrößenresultat darstellen. Auch, wenn hierbei über alle Aufmaßgrößen 2a bzw. über alle derart ermittelten Aufmaßgrößenresultate summiert wird, ist das Ergebnis wiederum ein Aufmaßgrößenresultat.

Im Übrigen sind in der Figur 23b dargestellten Ausführungsform die layerebenenspezifischen Berechnungsvorschriften 100a-e außerhalb der Layerebenen 1a-e dargestellt.

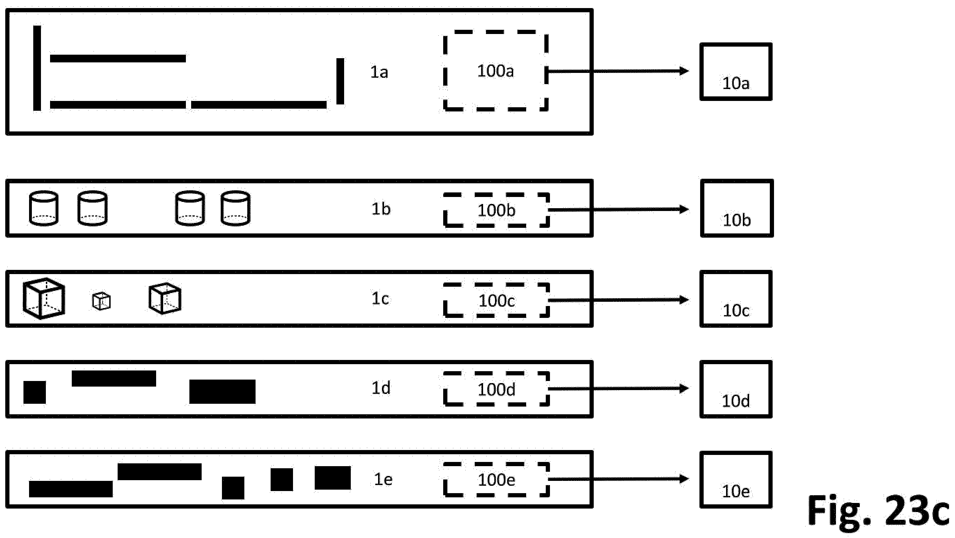

In der Figur 23c ist dies anders. Die layerebenenspezifischen Berechnungsvorschriften 100a-e können sich also auch in den Layerebenen 1a-e befinden. Dies spart Ressourcen. Beispielsweise kann hierbei auch auf vorhandene Infrakstruktur, beispielsweise von zeitgemäßen PDF-Programmen, zurückgegriffen werden. Auch die Anwendung der layerebenenspezifischen Berechnungsvorschriften 100a-e kann in diesem Zusammenhang beispielsweise in den Layerebenen stattfinden.

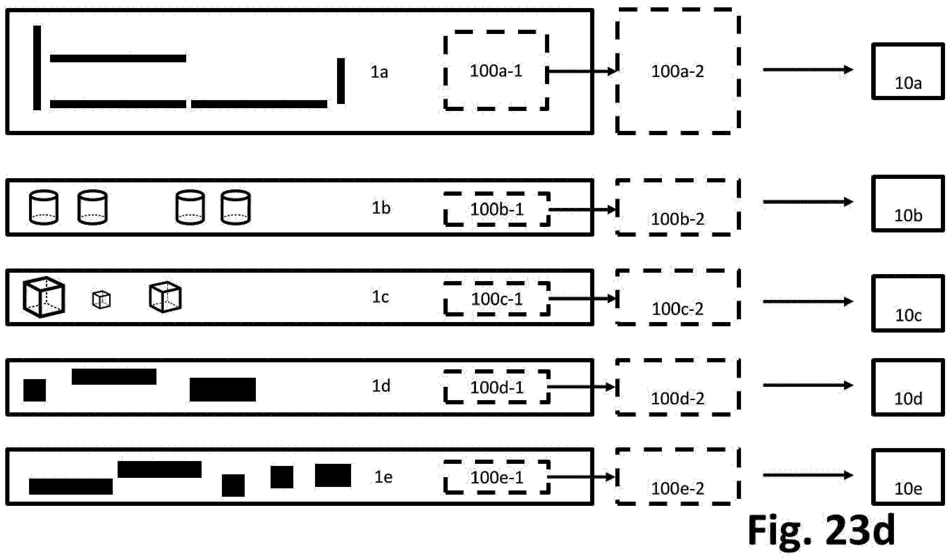

In der Figur 23d ist eine Ausführungsform der Erfindung dargestellt, wo die layerebenenspezifischen Berechnungsvorschriften 100a-e teilweise layerintern und teilweise extern realisiert sind. Beispielsweise gibt es eine layerinterne Teilberechnungsvorschrift 100a-1 und eine externe zweite Teilberechnungsvorschrift 100a-2, welche jedoch auch der Layerebene 1a zugeordnet ist. Die Erfindung ist im Hinblick auf den genauen Ort der Ausführung einer layerebenenspezifischen Berechnungsvorschrift als auch auf den Ort einer Bereithaltung/Speicherung einer layerebenenspezifischen Berechnungsvorschrift keineswegs limitiert.

Auch Kombinationen der hier dargestellten Ausführungsformen sind uneingeschränkt möglich.

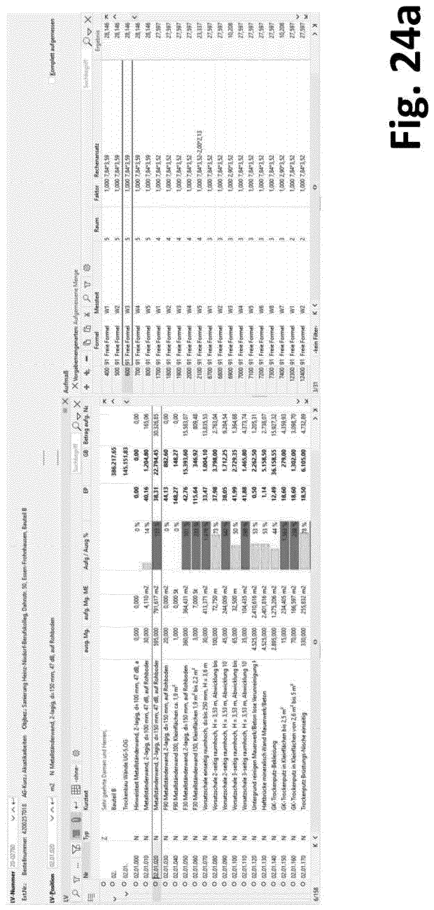

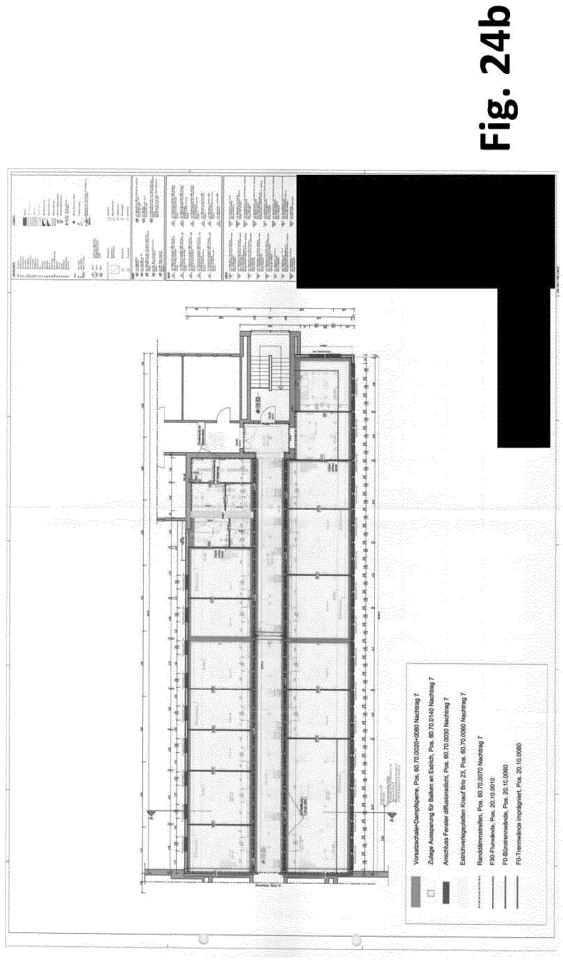

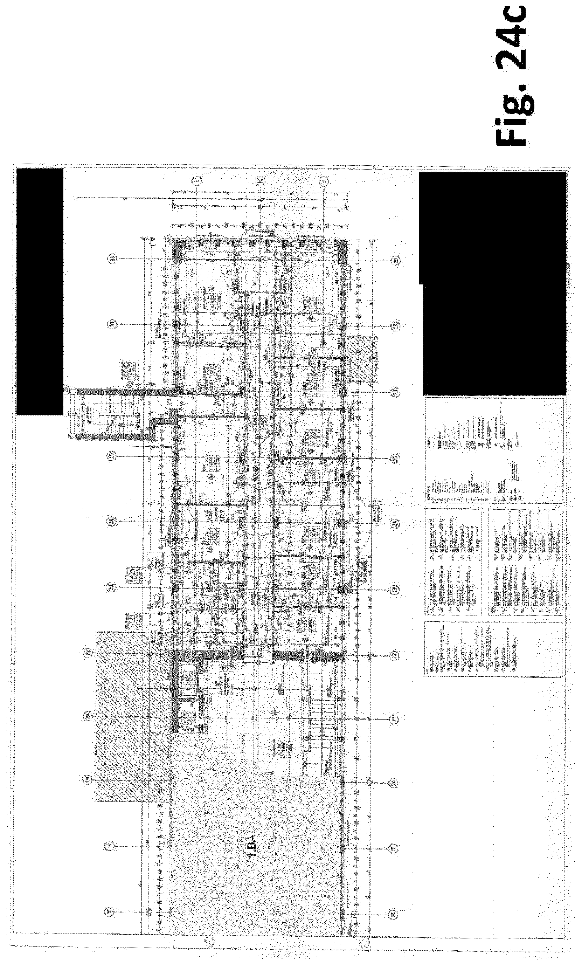

Die Figuren 24a-c demonstrieren einen herkömmlichen Ansatz nach dem Stand der Technik. Die Figur 24a zeigt dabei ein Leistungsverzeichnis samt Aufmaß. Die Figuren 24b,c zeigen die einschlägigen Bauzeichnungen.

Für jede Aufmaßzeile wurde manuell der "Rechenansatz" eingegeben.

Aufmaßobjekte werden von einem Prüfer in der bautechnischen Zeichnungen manuell aufgefunden auf Grundlage der Angaben "Raum" und "Messtext".

Es leuchtet bereits anhand dieses einfachen Beispiels ein, dass der angesprochene "Einwand der praktischen Unprüfbarkeit eines Aufmaßes" gemäß VOB/B im Arbeitsalltag eine enorme Rolle einnimmt - und dass die Erfindung hier Abhilfe schafft.

## Bezugszeichenliste

1a-e   Layerebene
2a-e   Aufmaßobjekte (samt zugehöriger Aufmaßgrößen)
10a-e   Ergebnis/Aufmaßgrößenresultat
100a-e   layerebenenspezifische Berechnungsvorschrift

## Patentansprüche

1. **Computerprogramm** für ein Aufmaß eines Gebäudes, Gebäudeteils oder anderweitigen Bauobjektes oder -projektes unter Nutzung mindestens einer bautechnischen Zeichnung,

welches dazu eingerichtet ist, ein Aufmaß ein oder mehrerer in der Zeichnung verzeichneter Leistungspositionen bereitzustellen und/oder vorzunehmen durch ein Aufmessen einer oder mehrerer Aufmaßgrößen,
dadurch charakterisiert, dass
die Aufmaßgrößen Layerebenen (1a-e) zugeordnet werden, wobei den Layerebenen (1a-e) layerebenenspezifische Berechnungsvorschriften (100a-e) zugeordnet werden, welche zwischen den einzelnen Layerebenen (1a-e) variieren können,
und das Computerprogramm ferner dazu eingerichtet ist, die Aufmaßgrößen einer Layerebene (1a-e) entsprechend der layerebenenspezifischen Berechnungsvorschriften (100a-e) der jeweiligen Layerebene (1a-e) weiterzuverarbeiten unter Erhalt eines Aufmaßgrößenresultats (10a-e), und das erhaltene Aufmaßgrößenresultat (10a-e) bereitzustellen und/oder auszugeben.

2. Computerprogramm nach Anspruch 1, wobei ferner den Layerebenen (1a-e) Aufmaßobjekte (2a-e) zugeordnet werden, welche auf eine aufzumessende Leistungsposition verweisen, und die Aufmaßgrößen auf Basis der Aufmaßobjekte (2a-e) ermittelt werden.

3. **Computerimplementiertes Verfahren zum Aufmessen** von Leistungspositionen in Bezug auf mindestens eine bautechnische Zeichnung, umfassend:

- Bereitstellen mindestens einer Layerebene (1a-e) zur Aufnahme von Aufmaßobjekten (2a-e)
- Bereitstellen oder Vornehmen eines Aufmaßes für eine oder mehrere Leistungspositionen mit Hilfe von Aufmaßobjekten (2a-e) unter Zuordnung der Aufmaßobjekte (2a-e) zu einer Layerebene (1a-e)
- Bereitstellen einer layerebenenspezifischen Berechnungsvorschrift (100a-e) und Zuordnen der layerebenenspezifischen Berechnungsvorschrift (100a-e) zu einer Layerebene (1a-e)
- Ermitteln mindestens einer Aufmaßgröße auf Basis eines Aufmaßobjektes (2a-e)
- Weiterverarbeiten mindestens einer Aufmaßgröße einer Layerebene (1a-e) entsprechend der layerebenenspezifischen Berechnungsvorschriften (100a-e) der jeweiligen Layerebene (1a-e) unter Erhalt mindestens eines Aufmaßgrößenresultats (10a-e)
- Bereitstellen und/oder Ausgeben eines erhaltenen Aufmaßgrößenresultates (10a-e).

**4.** Verfahren nach Anspruch 3, wobei der Schritt des Weiterverarbeitens in einem zu der Layerebene gehörigen und/oder der Layerebene, insbesondere eindeutig, zugeordneten Datenbereich, insbesondere Speicherbereich in einem flüchtigen oder nichtflüchtigen Computerspeicher, erfolgt und/oder wobei der Schritt des Weiterverarbeitens in der Layerebene selbst stattfindet.

**5.** Verfahren nach einem der Ansprüche 3 oder 4, wobei die Aufmaßobjekte und/oder Aufmaßgrößen einer Layerebene für den Nutzer darstellbar und gemeinsam ein- und ausblendbar sind, wobei insbesondere die Aufmaßobjekte und/oder Aufmaßgrößen ausgewählter Layerebenen einzeln und/oder im Kombination dargestellt werden können, insbesondere jeweils auch vor neutraler Grundierung, welche die bautechnische Zeichnung im Hintergrund ausblendet/opak, insbesondere jedenfalls semi-opak, überdeckt.

**6.** Verfahren nach einem der Ansprüche 3 - 5, wobei mindestens eine bautechnische Zeichnung im PDF-Format als bautechnische PDF-Zeichnung vorliegt, wobei für die Realisierung der genannten Layerebenen entsprechende Layer in der PDF-Zeichnung zum Einsatz gebracht werden.

**7.** Verfahren nach Anspruch 6, wobei mindestens eine layerebenenspezifische Berechnungsvorschrift im PDF-Dokument bereitgestellt und/oder in dieses übertragen wird, und wobei die layerebenenspezifische Berechnungsvorschrift innerhalb des PDF-Dokuments zur rechnerischen Anwendung gebracht wird, insbesondere unter Nutzung einer entsprechenden Funktion eines PDF-Anzeige-und/oder PDF-Verarbeitungsprogrammes zur Auswertung einer Berechnungsvorschrift.

**8.** Verfahren nach einem der Ansprüche 3 - 7, wobei eine Leistungsposition auf Basis mindestens eines Aufmaßgrößenresultats erzeugt, ergänzt und/oder geprüft wird, insbesondere ferner umfassend einen Schritt eines Erstellens, Ergänzens oder Füllens eines Leistungsverzeichnisses aus/mit den Leistungspositionen.

**9.** Verfahren nach einem der Ansprüche 3 - 8, wobei ein präzises Aufmaß unter Nutzung eines Maßstabes und unter Nutzung von Fangpunkten in der mindestens einen bautechnischen Zeichnung, insbesondere in einer bautechnischen PDF-Zeichnung, erreicht wird.

**10.** Verfahren nach einem der Ansprüche 3 - 9, umfassend einen Schritt eines automatisierten Nummerierens und/oder Bezeichnens von Aufmaßobjekten, insbesondere ferner umfassend eine graphische Darstellung einer Objektnummer und/oder eines Objektbezeichners, insbesondere ein konsekutives automatisches Nummerieren der Aufmaßobjekte je Layerebene, wobei eine Nummer innerhalb einer Layerebene nur jeweils einem eindeutigen Aufmaßobjekt zugeordnet wird, insbesondere Verfahren durchgeführt wird unter Nutzung eines Computerprogrammes nach Anspruch 1 oder 2.

**11. Computerimplementiertes Verfahren zum Prüfen eines Aufmaßes** auf Korrektheit, umfassend

- Bereitstellen mindestens einer Layerebene (1a-e) zur Aufnahme von Aufmaßobjekten (2a-e)
- Bereitstellen einer layerebenenspezifischen Berechnungsvorschrift (100a-e), welche der mindestens einen Layerebene (1a-e) zugeordnet ist
- Bereitstellen eines Aufmaßgrößenresultats (10a-e), welches zu prüfen ist, in Bezug auf eine Leistungsposition eines Leistungsverzeichnisses
- Prüfen, insbesondere Veri- oder Falsifizieren, insbesondere indirektes Prüfen, eines Aufmaßgrößenresultats (10a-e), umfassend die folgenden zwei Unterschritte:

  ∘ Prüfen von Aufmaßgrößen in Bezug auf Aufmaßobjekte (2a-e) der mindestens einen Layerebene (1a-e)
  o Prüfen der layerebenenspezifischen Berechnungsvorschrift (100a-e).

**12.** Verfahren nach Anspruch 11, wobei der Unterschritt des Prüfens von Aufmaßgrößen in Bezug auf Aufmaßobjekte der mindestens einen Layerebene ein graphisches Prüfen umfasst, insbesondere unter Einblenden einer zu prüfenden Layerebene und Ausblenden mindestens einer anderen Layerebene, insbesondere durch graphisches Prüfen der Layerebene vor der entsprechenden bautechnischen Zeichnung, ferner insbesondere durch graphisches Prüfen der Layerebene vor neutraler Grundierung, beispielsweise weißer Grundierung, insbesondere Verfahren durchgeführt unter Nutzung eines Computerprogrammes nach Anspruch 1 oder 2.

**13. Computerlesbare Aufmaßdaten** in Bezug auf mindestens eine bautechnische Zeichnung in einer computerlesbaren Form und/oder als Datensignal, umfassend eine Aufteilung in mehrere Layerebenen (1a-e), umfassend:

- Aufmaßobjekte (2a-e) sowie zugehörige Aufmaßgrößen, welche den Layerebenen (1a-e) zugeordnet sind
- mindestens eine layerebenenspezifische Berechnungsvorschrift (100a-e), welche jeweils einer Layerebene (1a-e) zugeordnet ist

- mindestens ein Aufmaßgrößenresultat (10a-e), welches sich dadurch ergibt, dass die layerebenenspezifische Berechnungsvorschrift (100a-e) einer Layerebene (1a-e) auf mindestens eine Aufmaßgröße der besagten Layerebene (1a-e) angewandt wird, oder ein hieraus abgeleitetes weiteres Resultat (10a-e), insbesondere die Summe (10a-e) der Ergebnisse der Berechnungen der Anwendung der layerebenenspezifischen Berechnungsvorschrift (100a-e) auf sämtliche in einer Layerebene (1a-e) vorhandene Aufmaßgrößen.

14. **Vorrichtung,** insbesondere Computer oder Computernetzwerk, welche dazu eingerichtet ist

    - das Computerprogramm nach Anspruch 1 oder 2 auszuführen,
    - ein Verfahren nach einem der Ansprüche 3 - 12 zu bewirken und/oder
    - computerlesbare Aufmaßdaten nach Anspruch 13 zu speichern und/oder zu verarbeiten.

15. **Computerlesbarer Datenträger** mit dem Computerprogramm nach Anspruch 1 oder 2, mit Anweisungen zur Bewirkung eines Verfahrens nach einem der Ansprüche 3 - 12 und/oder mit computerlesbaren Aufmaßdaten nach Anspruch 13.

16. **Verwendung** eines Computerprogrammes nach Anspruch 1 oder 2, eines Verfahrens nach einem der Ansprüche 3 - 12, von computerlesbaren Aufmaßdaten nach Anspruch 13, einer Vorrichtung nach Anspruch 14 und/oder eines computerlesbaren Datenträgers nach Anspruch 15
bei einem Architekten, bei einem Bauherrn, einem Vertragsnehmer zur Ausführung einer Bauleistung und/oder einem Prüfer zur Prüfung von Bauleistungen.

EP 4 276 726 A1

**Fig. 1**

22-13320 Beispiel LV Veoplan

Datei  Bearbeiten  Hilfe

Layer ausblenden          **Aufmasswert: 0,00 EUR**

Layer definieren  Zeichnung bearbeiten  Aufmaßobjekte  Aufmasszeilen

**Layer für PDF-Dateien**

| Pos. | Kurztext | Ausgeschr. | Aufgem. | Ausg./Aufg. | E.P. | Einh. |
|---|---|---|---|---|---|---|
| 39. | Trockenbauarbeiten | | | | | |
| 39.01. | DECKEN | | | | | |
| 39.01.010 | Deckenschürze, Höhe 51,5 cm | 275,000 | | | 59,88 | m |
| 39.01.010 | 39.01.010  Deckenschürze, Höhe 51,5 cm, (m), Polylinie (... | | | | | |
| 39.01.020 | Zulage Ausschnitte 500x150 | 51,000 | | | 11,50 | Stck |
| 39.01.040 | Zulage Ausschnitte DN 70 | 102,000 | | | 4,60 | Stck |
| 39.01.050 | Rasterdecke 625x625 mm, h= 50 mm, Brillianto A, 20 mm | 415,000 | | | 35,71 | m2 |
| 39.01.070 | Zulage Wandprofil Stufenwinkel | 550,000 | | | 5,86 | m |
| 39.02. | WÄNDE | | | | | |
| 39.02.150 | Metallständerwand d= 115 mm, Rw,P= 45 dB, Lehmplat... | 615,000 | | | 85,19 | m2 |
| 39.02.170 | Armierungslage auf Lehmplatten | 1230,000 | | | 24,27 | m2 |
| 39.02.240 | Zulage Ecken 90° | 22,000 | | | 8,82 | m |
| 39.02.270 | Zulage UA-Profile WC-Tragständer | 32,000 | | | 7,09 | m |

| Posnr. | Bezeichnung | Berechnung | Formel | Abzug |
|---|---|---|---|---|
| 39.01.010 | Deckenschürze, Höhe 51,5 cm | Polylinie (Umfang) | | |

Polygon (Fläche)
Polygon + Formel
Polylinie (Umfang)
Polylinie + Formel
Oval (Stück)
Oval + Formel
Rechteck (Stück)
Rechteck + Formel
Freitext

Layer neu  →
Layer löschen  ×

**Langtext**

Senkrechte Gipskarton-Schürzen
abgehangen von Stahlbetondecke,
**Wanddicke: 125 mm**
Höhe der Abschottung: ca. 51,5 cm
Arbeitshöhe von ca. 2,50 m bis 3,05 m
**Unterkonstruktion** bestehend aus
entsprechenden verzinkten Stahlblechprofilen
nach DIN 18182/Teil-1, unteres Sturzprofil

Mandantendatenbank: D:\Bau-SU\DATA\RIPPIN\RIPPIN.GDB

EP 4 276 726 A1

# Fig. 2

Fig. 3

Fig. 4

EP 4 276 726 A1

22-13320 Beispiel LV Veoplan

Datei  Bearbeiten  Hilfe

Layer ausblenden     Aufmasswert: 0,00 EUR

Layer definieren  Zeichnung bearbeiten  Aufmaßobjekte  Aufmaszeilen

**Layer für PDF-Dateien**

| Pos. | Kurztext | Ausgeschr. | Aufgem. | Ausg./Aufg. | E.P. | Einh. |
|------|----------|-----------|---------|-------------|------|-------|
| 39. | Trockenbauarbeiten | | | | | |
| 39.01. | **DECKEN** | | | | | |
| 39.01.010 | Deckenschürze, Höhe 51,5 cm | 275,000 | | | 59,88 | m |
| 39.01.010 | 39.01.010  Deckenschürze, Höhe 51,5 cm, [m], Polylinie (... | | | | | |
| 39.01.020 | Zulage Ausschnitte 500x150 | 51,000 | | | 11,50 | Stck |
| 39.01.020 | 39.01.020  Zulage Ausschnitte 500x150, [Stck], Oval (Stück) | | | | | |
| 39.01.040 | Zulage Ausschnitte DN 70 | 102,000 | | | 4,60 | Stck |
| 39.01.040 | 39.01.040  Zulage Ausschnitte DN 70, [Stck], Freitext | | | | | |
| 39.01.050 | Rasterdecke 625x625 mm, h= 50 mm, Brillianto A, 20 mm | 415,000 | | | 35,71 | m2 |
| 39.01.050 | 39.01.050  Rasterdecke 625x625 mm, h= 50 mm, Brilliant... | | | | | |
| 39.01.070 | Zulage Wandprofil Stufenwinkel | 550,000 | | | 5,86 | m |
| 39.02. | **WÄNDE** | | | | | |
| 39.02.150 | Metallständerwand d= 115 mm, Rw,P= 45 dB, Lehmplatt... | 615,000 | | | 85,19 | m2 |
| 39.02.170 | Armierungslage auf Lehmplatten | 1230,000 | | | 24,27 | m2 |
| 39.02.240 | Zulage Ecken 90° | 22,000 | | | 8,82 | m |
| 39.02.270 | Zulage UA-Profile WC-Tragständer | 32,000 | | | 7,09 | m |

Layer neu →
Layer löschen ✕

| Posnr. | Bezeichnung | Berechnung | Formel | Abzug |
|--------|-------------|-----------|--------|-------|
| 39.01.010 | Deckenschürze, Höhe 51,5 cm | Polylinie (Umfang) | | ☐ |
| 39.01.020 | Zulage Ausschnitte 500x150 | Oval (Stück) | | ☐ |
| 39.01.040 | Zulage Ausschnitte DN 70 | Freitext | | ☐ |
| 39.01.050 | Rasterdecke 625x625 mm, h= 50 mm, Brillianto A | Polygon (Fläche) | | ☐ |

Polygon (Fläche)
Polygon + Formel
Polylinie (Umfang)
Polylinie + Formel
Oval (Stück)
Oval + Formel
Rechteck (Stück)
Rechteck + Formel
Freitext

**Langtext**

Rasterdecke als Abhangdeckensystem
komplett liefern und einbauen.
**OWAconstruct System S 19 mit**
**OWAcoustic Mineralplatte Brillianto A**
Bezeichnung: Verdecktes System,
herausnehmbar, mit Schattenfuge
Serie: OWAlifetime collection
Hersteller: OWA

Mandantendatenbank: D:\Bau-SU\DATA\RIPPIN\RIPPIN.GDB

# Fig. 5

**Fig. 6**

22-13320 Beispiel LV Veoplan

Datei  Bearbeiten  Hilfe

Layer ausblenden          **Aufmasswert: 0,00 EUR**

Layer definieren  Zeichnung bearbeiten  Aufmaßobjekte  Aufmasszellen

**Layer für PDF-Dateien**

| Pos. | Kurztext | Ausgeschr. | Aufgem. | Ausg./Aufg. | E.P. | Einh. |
|---|---|---|---|---|---|---|
| 39. | Trockenbauarbeiten | | | | | |
| 39.01. | DECKEN | | | | | |
| 39.01.010 | Deckenschürze, Höhe 51,5 cm | 275,000 | | | 59,88 | m |
| 39.01.010 | 39.01.010  Deckenschürze, Höhe 51,5 cm, [m], Polylinie (... | | | | | |
| 39.01.020 | Zulage Ausschnitte 500x150 | 51,000 | | | 11,50 | Stck |
| 39.01.020 | 39.01.020  Zulage Ausschnitte 500x150, [Stck], Oval (Stü... | | | | | |
| 39.01.040 | Zulage Ausschnitte DN 70 | 102,000 | | | 4,60 | Stck |
| 39.01.040 | 39.01.040  Zulage Ausschnitte DN 70, [Stck], Freitext | | | | | |
| 39.01.050 | Rasterdecke 625x625 mm, h= 50 mm, Brillianto A, 20 mm | 415,000 | | | 35,71 | m2 |
| 39.01.050 | 39.01.050  Rasterdecke 625x625 mm, h= 50 mm, Brillian... | | | | | |
| 39.02. | WÄNDE | | | | | |
| 39.02.150 | Metallständerwand d= 115 mm, Rw,P= 45 dB, Lehmplatt... | 615,000 | | | 85,19 | m2 |
| 39.02.150 | 39.02.150  Metallständerwand d= 115 mm, Rw,P= 45 dB... | | | | | |
| 39.02.240 | Zulage Ecken 90° | 22,000 | | | 8,82 | m |
| 39.02.240 | 39.02.240  Zulage Ecken 90°, [m], Oval + Formel, 3,20 | | | | | |
| 39.02.270 | Zulage UA-Profile WC-Tragständer | 32,000 | | | 7,09 | m |

Layer neu →

Layer löschen ✕

| Posnr. | Bezeichnung | Berechnung | Formel | Abzug |
|---|---|---|---|---|
| 39.01.010 | Deckenschürze, Höhe 51,5 cm | Polylinie (Umfang) | | ☐ |
| 39.01.020 | Zulage Ausschnitte 500x150 | Oval (Stück) | | ☐ |
| 39.01.040 | Zulage Ausschnitte DN 70 | Freitext | | ☐ |
| 39.01.050 | Rasterdecke 625x625 mm, h= 50 mm, Brillianto | Polygon (Fläche) | | ☐ |
| 39.02.150 | Metallständerwand d= 115 mm, Rw,P= 45 dB, L | Polygon + Formel | a*3,20 | ☐ |
| 39.02.240 | Zulage Ecken 90° | Oval + Formel | 3,20 | ☐ |

**Langtext**

Zulage zu Montagewand für Ecken,
Winkel 90° inkl. Eckschutzschienen
liefern und einspachteln.

Mandantendatenbank: D:\Bau-SU\DATA\RIPPIN\RIPPIN.GDB

# Fig. 7

**Fig. 8**

Fig. 9

Fig. 10a

Fig. 10b

Fig. 11

Fig. 12

Fig. 13

Fig. 14

Fig. 15

EP 4 276 726 A1

Fig. 16

32

**Fig. 17**

Fig. 18

**Fig. 19**

EP 4 276 726 A1

Rippin GmbH

SYSTEM + DESIGN

Herr
Max Muster
Musterstr. 3
45872 Musterstadt

Wesel, den 02.05.2022

**Rechnung  Nr. 807**

**LV-Nr.:**        **22-13320**
**Bauvorhaben: Beispiel LV Veoplan**
**Auftrag-Nr.:    Beispiel LV Veoplan**

Sehr geehrter Herr Muster,

nach Fertigstellung unserer Leistungen erlauben wir uns, den entsprechenden Betrag in Rechnung zu stellen.

Wir bedanken uns für Ihren Auftrag und stehen Ihnen auch nach Abschluss der Arbeiten jederzeit gerne zur Verfügung.

Mit freundlichen Grüßen

Lutz Rippin

---

Rippin GmbH

SYSTEM + DESIGN

**Rechnung**

Auftraggeber: Rippin GmbH
Objekt:       22-13320
              Beispiel LV Veoplan

Rechnungsdatum:  02.05.2022
Rechnungsnummer: 807
Externe Nummer:  Beispiel LV Veoplan

Leistungszeitraum: 04.04.2022 bis 02.05.2022

| Positionsnummer | Bezeichnung | Menge EH | EP [EUR] | GP [EUR] |
|---|---|---|---|---|
| **39.** | **Trockenbauarbeiten** | | | |
| **39.01.** | **DECKEN** | | | |
| 39.01.010 | Deckenschürze, Höhe 51,5 cm | 35,750 m | 59,88 | 2.140,71 |
| 39.01.020 | Zulage Ausschnitte 500x150 | 7,000 Stck | 11,50 | 80,50 |
| 39.01.040 | Zulage Ausschnitte DN 70 | 42,000 Stck | 4,60 | 193,20 |
| 39.01.050 | Rasterdecke 625x625 mm, h= 50 mm, Brillianto A, 20 mm | 18,590 m2 | 35,71 | 663,85 |
| | **Titelsumme      39.01.      DECKEN** | | | **3.078,26** |
| **39.02.** | **WÄNDE** | | | |
| 39.02.150 | Metallständerwand d= 115 mm, Rw,P= 45 dB, Lehmplatten | 67,968 m2 | 85,19 | 5.790,19 |
| 39.02.240 | Zulage Ecken 90° | 9,600 m | 8,82 | 84,67 |
| 39.02.270 | Zulage UA-Profile WC-Tragständer | 44,800 m | 7,09 | 317,63 |
| | **Titelsumme      39.02.      WÄNDE** | | | **6.192,49** |
| | **Obertitelsumme   39.   Trockenbauarbeiten** | | | **9.270,75** |
| | **Rechnungsbetrag Netto** | | | **9.270,75** |
| | **zzgl. MwSt.** | | 19% | **1.761,44** |
| | **Rechnungsbetrag Brutto** | | | **11.032,19** |

# Fig. 20

EP 4 276 726 A1

**Fig. 21**

Fig. 22

**Fig. 23a**

EP 4 276 726 A1

Fig. 23b

Fig. 23c

Fig. 23d

Fig. 24a

Fig. 24b

Fig. 24c

Europäisches
Patentamt

European
Patent Office

Office européen
des brevets

**EUROPÄISCHER RECHERCHENBERICHT**

**Nummer der Anmeldung**

**EP 23 17 2164**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2021/073446 A1 (LEVY STEPHANE [IL] ET AL) 11. März 2021 (2021-03-11)<br>* Zusammenfassung *<br>* Absatz [0126] *<br>* Absatz [0661] – Absatz [0662] *<br>* Absatz [0680] *<br>----- | 1-16 | INV.<br>G06Q30/04<br>G06F30/13<br>G06Q50/08 |
| X | DE 10 2019 001164 A1 (OTTO FISCHER AG [CH]) 5. September 2019 (2019-09-05)<br>* Absatz [0008] – Absatz [0010] *<br>* Absatz [0021] *<br>* Absatz [0048] *<br>* Zusammenfassung; Abbildung 4 *<br>----- | 1-16 | |

**RECHERCHIERTE SACHGEBIETE (IPC)**

G06F
G06Q

Der vorliegende Recherchenbericht wurde für alle Patentansprüche erstellt

| Recherchenort | Abschlußdatum der Recherche | Prüfer |
|---|---|---|
| München | 20. September 2023 | Ross, Christopher |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 23 17 2164

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-09-2023

| Im Recherchenbericht angeführtes Patentdokument | Datum der Veröffentlichung | Mitglied(er) der Patentfamilie | | Datum der Veröffentlichung |
|---|---|---|---|---|
| US 2021073446 A1 | 11-03-2021 | EP | 4026037 A1 | 13-07-2022 |
| | | US | 2021073430 A1 | 11-03-2021 |
| | | US | 2021073433 A1 | 11-03-2021 |
| | | US | 2021073434 A1 | 11-03-2021 |
| | | US | 2021073435 A1 | 11-03-2021 |
| | | US | 2021073440 A1 | 11-03-2021 |
| | | US | 2021073441 A1 | 11-03-2021 |
| | | US | 2021073442 A1 | 11-03-2021 |
| | | US | 2021073446 A1 | 11-03-2021 |
| | | US | 2021073447 A1 | 11-03-2021 |
| | | US | 2021073448 A1 | 11-03-2021 |
| | | US | 2021073449 A1 | 11-03-2021 |
| | | US | 2021256180 A1 | 19-08-2021 |
| | | US | 2021383037 A1 | 09-12-2021 |
| | | US | 2023153485 A1 | 18-05-2023 |
| | | WO | 2021044216 A1 | 11-03-2021 |
| DE 102019001164 A1 | 05-09-2019 | AT | 17882 U1 | 15-06-2023 |
| | | AT | 520946 A2 | 15-09-2019 |
| | | CH | 714707 A1 | 13-09-2019 |
| | | DE | 102019001164 A1 | 05-09-2019 |
| | | FR | 3078578 A1 | 06-09-2019 |

EPO FORM P0461

Für nähere Einzelheiten zu diesem Anhang : siehe Amtsblatt des Europäischen Patentamts, Nr.12/82